## Europäisches Patentamt
## European Patent Office
## Office européen des brevets

(19)

(11) Veröffentlichungsnummer: **0 111 086**
**B1**

(12)

# EUROPÄISCHE PATENTSCHRIFT

(45) Veröffentlichungstag der Patentschrift:
08.03.89

(21) Anmeldenummer: 83109945.2

(22) Anmeldetag: 05.10.83

(51) Int. Cl.⁴: **H 01 L 21/31,** H 01 L 21/308,
H 01 L 21/76

(54) Verfahren zum Herstellen von Strukturen mit Abmessungen im Submikrometerbereich und die Anwendung dieses Verfahrens zur Herstellung einer tiefen dielektrischen Isolation mit Submikrometerbreite in einem Siliciumkörper.

(30) Priorität: 13.11.82 DE 3242113

(43) Veröffentlichungstag der Anmeldung:
20.06.84 Patentblatt 84/25

(45) Bekanntmachung des Hinweises auf die Patenterteilung:
08.03.89 Patentblatt 89/10

(84) Benannte Vertragsstaaten:
DE FR GB IT NL

(56) Entgegenhaltungen:
EP-A-0 010 624
EP-A-0 043 943
EP-A-0 061 729
GB-A-2 110 876
US-A-4 331 708

(73) Patentinhaber: **IBM DEUTSCHLAND GMBH,
Pascalstrasse 100, D-7000 Stuttgart 80 (DE)**

(84) Benannte Vertragsstaaten: **DE**

(73) Patentinhaber: **International Business Machines
Corporation, Old Orchard Road, Armonk, N.Y.
10504 (US)**

(84) Benannte Vertragsstaaten: **FR GB IT NL**

(72) Erfinder: **Trumpp, Hans-Joachim, Dr.,
Eierwiesenstrasse 25, D-7024 Filderstadt 1
Bernhausen (DE)**
Erfinder: **Greschner, Johann, Dr., Tiergartenweg
14, D-7401 Pliezhausen (DE)**

(74) Vertreter: **Kreidler, Eva-Maria, Dr. rer. nat.,
Schönaicher Strasse 220, D-7030 Böblingen (DE)**

EP 0 111 086 B1

## Beschreibung

Die Erfindung betrifft ein Verfahren zum Herstellen von Strukturen mit Abmessungen im Submikrometerbereich und die Anwendung dieses Verfahrens zur Herstellung einer tiefen dielektrischen Isolation mit Submikrometerbreite in einem Siliciumkörper.

Es sind eine Reihe von Verfahren bekannt, die Integrationsdichte integrierter Schaltkreise zu steigern. Beachtliche Steigerungen der Integrationsdichte konnten in der letzten Zeit in erster Linie durch eine Senkung photolithographischer Defektdichten erzielt werden. Durch den Einsatz von Elektronen- und Röntgenstrahl-Belichtungsverfahren anstelle der bisher verwendeten Lichtstrahlung konnten Fortschritte in Richtung einer höheren optischen Auflösung gemacht werden. Darüber hinaus gab es weitere Bemühungen, sehr schmale Linienbreiten im Bereich von 1 μm und darunter durch Ausweitung standardmäßiger lithographischer Verfahren unter Vermeidung der kostenträchtigen Techniken der Elektronen- und Röntgenstrahllithographie zu erzielen. Mit der Technik des Plasma- oder reaktiven Ionenätzens zum Ätzen von Metallen, halbleitenden und dielektrischen Materialien konnten weitere Fortschritte in Richtung sehr schmaler Linienbreiten und damit zu einer höheren Integrationsdichte gemacht werden.

In einer Reihe von Veröffentlichungen und Patentschriften ist die sog. Seitenwandtechnologie beschrieben, mit welcher Strukturen im Submikrometerbereich hergestellt werden können. Es ist beispielsweise in IEEE Electron Device Letters, Vol. EDL-2, Nr. 1, Januar 1981, Seiten 4 bis 6, ein Verfahren beschrieben, bei dem vertikale (anisotrope) Trockenätzverfahren zur Herstellung von MOSFETs, welche durch eine Kante definiert sind und Dimensionen im Submikrometerbereich aufweisen, eingesetzt werden. Mit der beschriebenen Technologie können physikalische Kanallängen der MOSFETs im Bereich von 0,1 bis 0,15 μm hergestellt werden.

In der US-Patentschrift 4 358 340 ist ein Verfahren zur Herstellung von Submikrometervorrichtungen, jedoch ohne Anwendung der Submikrometerlithographie beschrieben, bei dem ein leitender Dünnfilm mit Abmessungen im Submikrometerbereich auf einer vertikalen Stufe zwischen benachbarten Oberflächen einer Isolation abgeschieden und dann vertikal geätzt wird, bis von dem leitenden Film nur noch der an der vertikalen Stufe anliegende Teil vorhanden ist. Die verbleibende, nicht von dem Leiter bedeckte Isolation wird entfernt unter Erhalt eines Gates eines MOS Feldeffekttransistors mit einer Breite im Submikrometerbereich, die gleich der Schichtdicke des ursprünglich aufgebrachten Dünnfilms ist.

In der US-Patentschrift 4 209 349 ist ein Verfahren zur Ausbildung sehr kleiner Maskenöffnungen für die Herstellung von Halbleiterschaltungsanordnungen beschrieben. Bei diesem Verfahren werden auf einem Substrat zunächst Bereiche einer ersten Isolierschicht ausgebildet, so daß im wesentlichen horizontale, sowie im wesentlichen vertikale Oberflächen vorliegen. Darüber wird eine zweite Isolierschicht aus gegenüber der ersten Isolierschicht verschiedenem Material aufgebracht und einem reaktiven Ionenätzverfahren derart unterzogen, daß die horizontalen Bereiche der zweiten Isolierschicht abgetragen werden und lediglich sehr schmale Bereiche dieser Schicht auf den vertikal gerichteten Oberflächenbereichen der ersten Isolierschicht bzw. den betreffenden Bereichen des Substrats verbleiben.. Anschließend wird eine thermische Oxidation der freiliegenden Substratbereiche vorgenommen und zur endgültigen Freilegung der gewünschten Maskenöffnungen die dort befindlichen Bereiche der zweiten Isolierschicht entfernt. Mit diesem Verfahren sollen sich kleinere als die mit bisher üblichen photolithographischen Verfahren bestimmten Minimaldimensionen erzielen lassen.

In dem Verfahren dieser US-Patentschrift bestimmt die erste Isolierschicht (Siliciumdioxid) die Position und Dicke der Maske (Spalte 2, Zeile 62). Alle Öffnungen in der Isolierschicht werden durch Standardphotolithographie und Ätztechniken hergestellt (Spalte 3, Zeile 21), bei denen keine vertikalen Seitenwände erhalten werden können. In dem erfindungsgemäßen Verfahren dagegen bestimmt eine Polymerschicht die Position und Dicke der Maske. In dem Verfahren der US-Patentschrift werden durchweg Heißprozesse durchgeführt, beispielsweise eine thermische Oxidation bei 970° C (Spalte 4, Zeile 65) und die Abscheidung von Siliciumnitrid aus der Gasphase bei ungefähr 1000° C (Spalte 5, Zeile 69), während bei dem erfindungsgemäßen Verfahren sog. Kaltprozesse unterhalb 300° C durchgeführt werden, die eine universellere Anwendbarkeit des Verfahrens gestatten. Mit dem Verfahren der US-Patentschrift sind Masken mit einer Schichtdicke < 0,5 μm herstellbar, welche als Masken z. B. zum Ätzen von tiefen Gräben nicht geeignet sind. Mit dem erfindungsgemäßen Verfahren dagegen können Masken mit einer Dicke von 2 bis 3 μm hergestellt werden, die zum Ätzen von 4 bis 5 μm tiefen Gräben in ein Siliciumsubstrat verwendet werden können. Aus der thermischen Oxidation (Spalte 4, Zeile 64 der US-Patentschrift) resultiert eine asymmetrische Maske, bei der das Vogelschnabelproblem, welches durch die Ausbildung eines nicht planaren Siliciumdioxids an der Oberfläche des Grabens zustandekommt, eine Rolle spielt, so daß die Maske auch aus diesem Grunde zum Ätzen von Gräben unbrauchbar wird. Die erfindungsgemäß hergestellte Maske weist streng vertikale Seitenwände auf und ist symmetrisch aufgebaut.

Allen bisher bekannten Verfahren ist gemeinsam, daß zur Herstellung von Strukturen mit vertikalen Seitenwänden und Dimensionen im Submikrometerbereich Materialien wie Polysilicium, Siliciumnitrid oder Siliciumdioxid, die durchweg bei höheren Temperaturen abgeschieden werden, verwendet werden. Die Verwendung von Polymermaterialien zu diesem Zweck ist in keiner der Veröffentlichungen beschrieben.

Die Anwendung des erfindungsgemäßen Verfahrens ist besonders vorteilhaft bei der Herstellung tiefer dielektrischer Isolationen mit Submikrometerbreite in einem Halbleiterkörper. Im folgenden wird kurz auf die verschiedenen Isolationsmethoden eingegangen. Eine der bekannten Isolationsmethoden, um verschiedene aktive und/oder passive Elemente in integrierten Schaltkreisstrukturen voneinander zu isolieren, ist die sog. Sperrschichtisolation, bei der Isolationswannen dadurch gebildet werden, daß Halbleiterbereiche mit entgegengesetzt dotierten Halbleiterzonen umgeben werden. Die dabei entstehenden Halbleiterübergänge bilden in Sperrichtung betriebene Dioden, welche die Isolation bewirken. Eine weitere bekannte Isolationsmethode ist die sog. dielektrische Isolation. Bei dieser werden die zu isolierenden Halbleiterbereiche mit einer dielektrischen Isolationswanne umgeben. Bei einer Ausführungsform derselben werden Gräben in Silicium gebildet, in denen dann die Isolationsbereiche ausgebildet werden. Während des Ätzens der Gräben wird die übrige Oberfläche des Halbleitersubstrats durch eine Schutzschicht geschützt, die aus einer Siliciumdioxid-Siliciumnitrid-Sandwichstruktur besteht. Im Anschluß an die Ausbildung der Gräben wird das Siliciumhalbleitersubstrat in konventioneller Weise einer Oxidation unterzogen, wodurch das Silicium im Bereich der Gräben oxidiert wird und das resultierende Siliciumdioxid die Gräben ausfüllt. Bei der herkömmlichen thermischen Oxidation zum Auffüllen der Gräben mit Oxid entstehen jedoch unerwünschte Strukturen an den Kanten der Gräben, die als "Vogelschnäbel" (Bird's Beak) bezeichnet werden. Mit Vogelschnäbeln wird die Ausbildung eines nicht planaren Siliciumdioxids an der Oberfläche des Grabens bezeichnet, welches durch die laterale Oxidation, die unterhalb der Siliciumdioxidschicht stattfindet, verursacht wird und eine Aufwölbung der Siliciumdioxid/Siliciumnitridstruktur an den Kanten des Grabens bewirkt. Dadurch ist das direkte Angrenzen von Diffusionen an die Isolation, welches einen wesentlichen Vorteil der ursprünglich geplanten dielektrischen Isolation darstellt, nicht mehr möglich.

Eine Alternative zu der eingelagerten Oxidisolation ist die tiefe, dielektrische Isolation, welche die Ausbildung von rechtwinkligen Gräben durch reaktive Ionenätzverfahren und die Auffüllung der Gräben zur Ausbildung der Isolation für die einzelnen Siliciumbereiche des Substrats umfaßt. Auch dieses Verfahren weist einige erhebliche Nachteile auf. So kann beispielsweise zur Auffüllung der Gräben kein thermisches Oxid verwendet werden, sondern nur ein Oxid, welches chemisch aus einer Silan- und Sauerstoff-haltigen Gasphase abgeschieden wird, oder Polysilicium. Das Auffüllen der Gräben mit Oxid durch chemische Abscheidung aus der Gasphase wiederum kann zu einer schlechten Oxidqualität bzw. einer Nahtlinie in der Mitte der Gräben führen, welche die Kontinuität des auf der Oberfläche verlaufenden metallischen Leiterzugs beeinflußen und schließlich Leitfähigkeitsfehler verursachen kann. Das chemisch aus der Gasphase abgeschiedene Oxid weist während der nachfolgenden verschiedenen Temperaturprozesse nicht den gleichen thermischen Ausdehnungskoeffizienten wie Silicium auf und führt bei Prozeßtemperaturen um 1000° C zu Spannungen um die Gräben. Des weiteren ist chemisch aus der Gasphase abgeschiedenes Oxid schwierig zu planarisieren.

Wünschenswert ist daher ein Verfahren, mit dem tiefe dielektrische Isolationen mit Submikrometerbreite hergestellt werden können, die die zuvor genannten Nachteile nicht aufweisen. Außerdem wird angestrebt, dielektrische Isolationen mit einer Breite von ungefähr 1 µm und einer Tiefe von etwa 5 µm in Siliciumhalbleitersubstraten herzustellen.

Die Erfindung, wie sie in den Ansprüchen gekennzeichnet ist, löst die Aufgabe, ein verbessertes Lithographieverfahren mit verringerten Linienbreiten bis in den Submikrometerbereich hinein anzugeben. Gegenstand der Erfindung ist auch die Anwendung dieses Verfahrens zur Herstellung tiefer dielektrischer Isolationen mit Breiten im Submikrometerbereich.

Zusammengefaßt wird gemäß dem Verfahren der Erfindung eine Struktur aus Polymermaterial mit vertikalen Seitenwänden hergestellt, wobei die letzteren zur Ausbildung von Seitenwandstrukturen aus Siliciumoxid oder -nitrid mit Dimensionen im Submikrometerbereich dienen. Diese Seitenwandstrukturen können direkt als Masken verwendet werden. Für die negative Lithographie wird alternativ eine weitere Schicht über den Seitenwandstrukturen aufgetragen, diese bis zur Freilegung der Spitzen der Seitenwandstrukturen abgetragen und dieselben entfernt. Die resultierende Öffnung kann dann als Maske für eine Vielzahl von Prozessen zur Herstellung integrierter Schaltkreise verwendet werden. Die Erfindung umfaßt auch eine Anwendung des Verfahrens zur Herstellung tiefer dielektrischer Isolationen mit Submikrometerbreite in einem Siliciumhalbleiterkörper.

Die Erfindung wird im folgenden unter Zuhilfenahme der Zeichnungen näher erläutert.

Es zeigen:

Fign. 1A bis 1F den grundsätzlichen Ablauf des Verfahrens für negative Lithographie;

Fign. 2A bis 2C den grundsätzlichen Ablauf des Verfahrens für positive Lithographie;

Fig. 3 eine Dreilagenstruktur zur Herstellung eines vertikalen Profils aus Polymermaterial;

Fig. 4 das Ätzen eines vertikalen Polymerprofils;

Fig. 5 die Abscheidung von Siliciumnitrid oder -oxid auf den horizontalen und vertikalen Oberflächen der Struktur aus Polymermaterial;

Fig. 6 die Herstellung von Siliciumnitrid- oder -oxidwänden durch Ätzen;

Fig. 7A die Abscheidung des eigentlichen Maskenmaterials;

Fign. 7B und 7C Varianten des Verfahrens zur Abscheidung von Maskenmaterial und zur Planarisierung der Oberfläche;

Fig. 8 die Entfernung der in das Maskenmaterial eingebetteten Siliciumnitrid- oder -oxidwände;

Fig. 9 das Öffnen der Maske bis zum Substrat durch reaktives Ionenätzen;

Fig. 10 das Ätzen tiefer Gräben in das Substrat unter Verwendung der Maske;

Fig. 11 das Auffüllen dieser Gräben durch thermische Oxidation;

Fig. 12 das Abätzen des Siliciumdioxids von der Oberfläche und die anschließende Reoxidation;

Fig. 13 das Auffüllen der Gräben mit Kunststoff;

Fig. 14 die Umkehrung der Seitenwandstruktur von Fig. 6 in eine Maske aus einem anderen Material, aber mit identischen Dimensionen (positive Lithographie);

Fig. 15 die fertiggestellte Maske aus dem anderen Material;

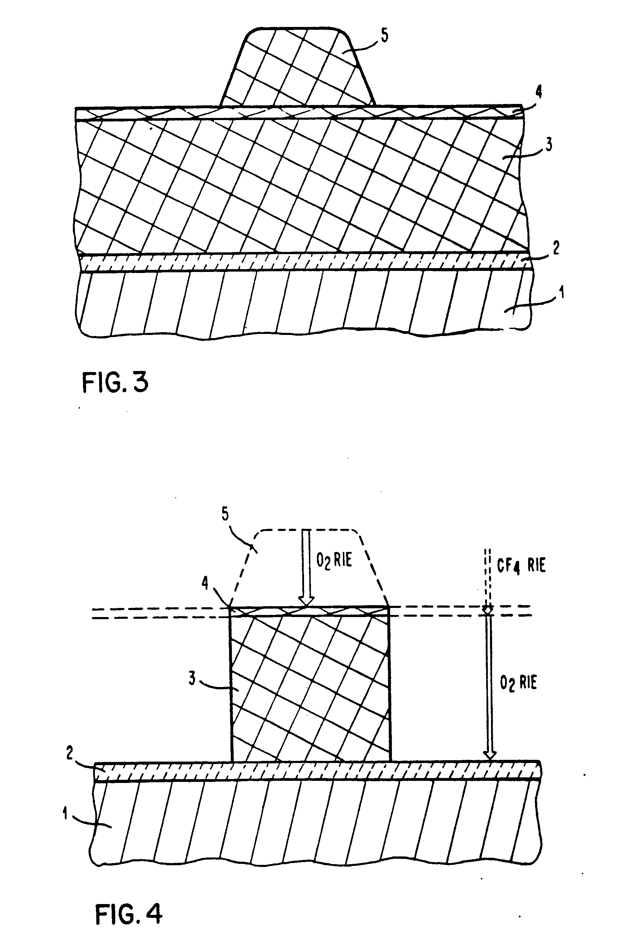

SEM 1 (Sekundärelektronenmikroskop- oder Rasterelektronenmikroskopaufnahme) entspricht Fig. 4 und zeigt ein Photoresistprofil als Beispiel eines Polymermaterials mit vertikalen Seitenwänden;

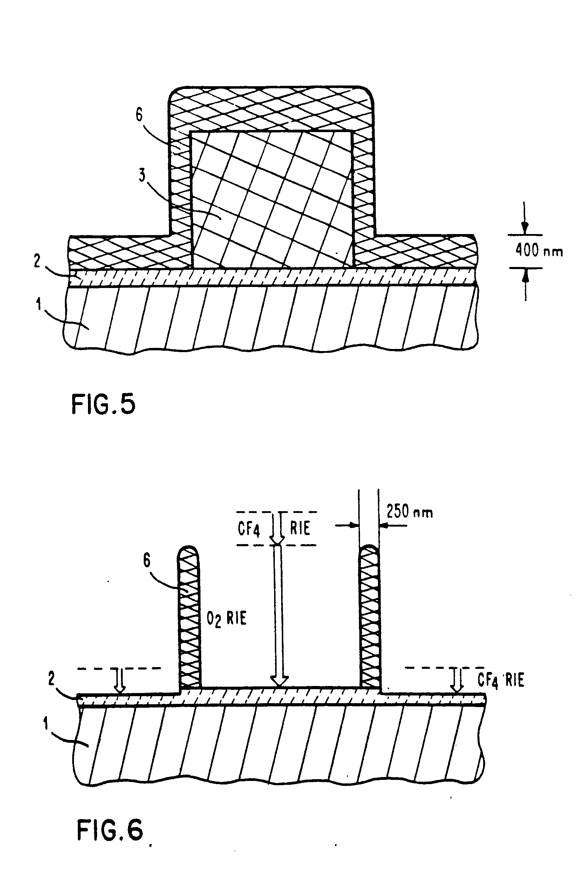

SEM 2 entspricht Fig. 5 und zeigt den mit Siliciumnitrid bedeckten Photoresist mit vertikalen Seitenwänden;

SEM 3 entspricht Fig. 6 und zeigt etwa 0,3 μm breite Wände aus Siliciumnitrid;

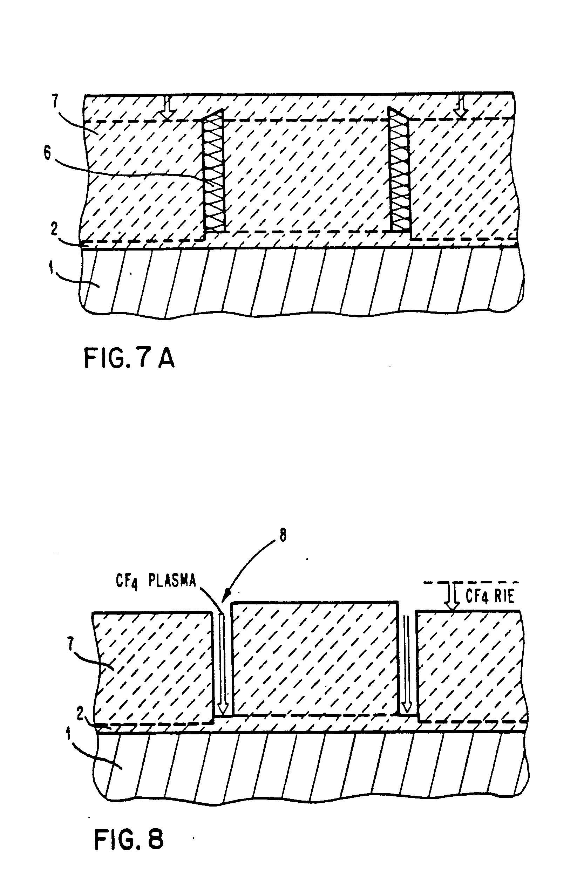

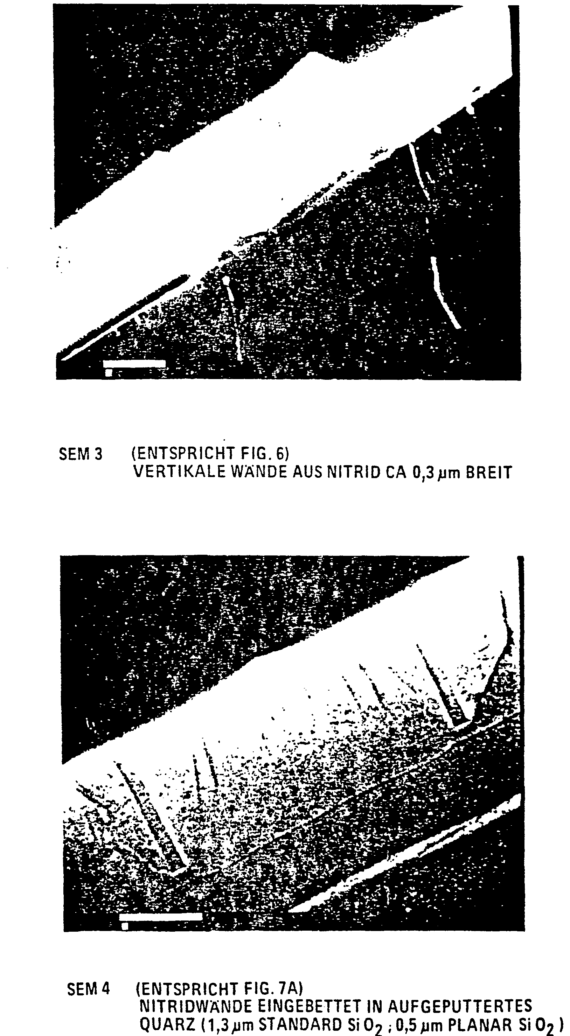

SEM 4 entspricht Fig. 7A und zeigt Siliciumnitridwände, eingebettet in mittels Kathodenzerstäubung aufgetragenes Siliciumdioxid;

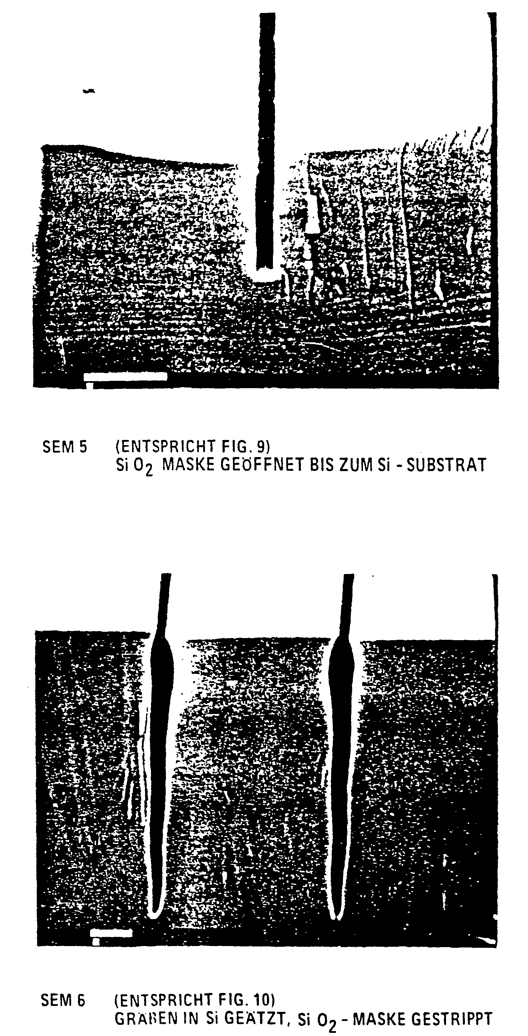

SEM 5 entspricht Fig. 9 und zeigt eine Siliciumdioxidmaske, die bis zum Siliciumsubstrat geöffnet ist;

SEM 6 entspricht Fig. 10 und zeigt die tiefen Gräben im Silicium, wobei die Siliciumdioxidmaske bereits entfernt ist;

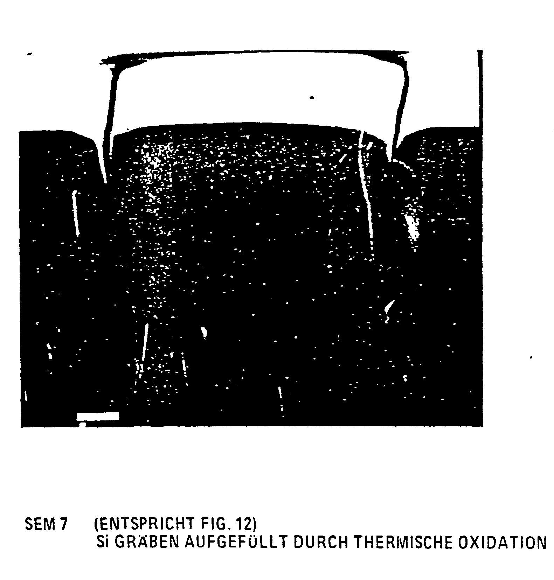

SEM 7 entspricht Fig. 12 und zeigt die Gräben nach dem Auffüllen durch thermische Oxidation.

Mit dem erfindungsgemäßen Verfahren können in einem bevorzugten Ausführungsbeispiel Siliciumdioxid-Ätzmasken mit nur 0,2 μm breiten Öffnungen mit vertikalen Seitenwänden hergestellt werden. Diese wiederum werden verwendet zum Ätzen von Gräben in das Siliciumsubstrat mit einer Breite von 0,5 μm. Die Gräben werden anschließend mit dielektrischem Material aufgefüllt.

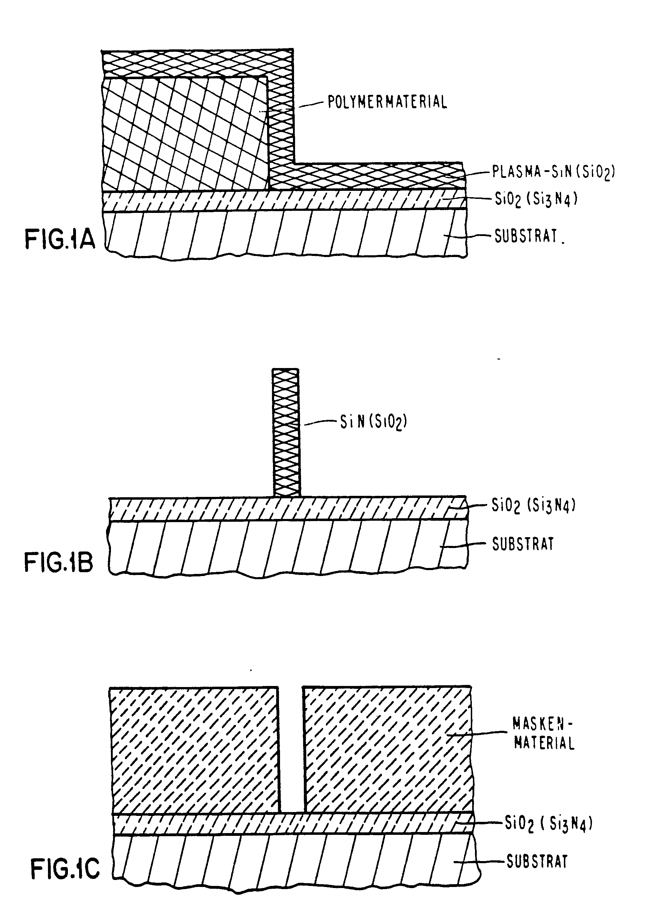

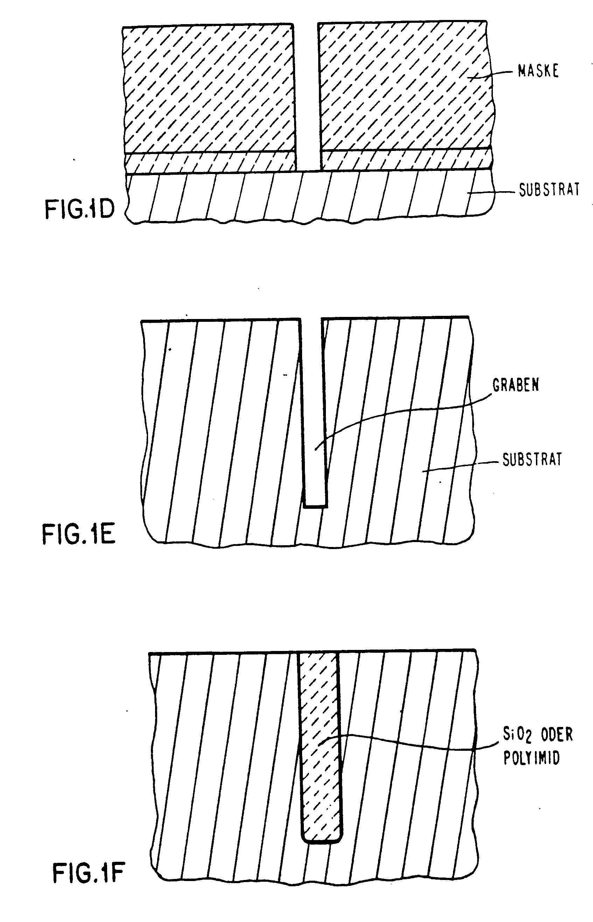

Zur Herstellung einer Ätzmaske in einem negativen Lithographieverfahren sind nach dem grundsätzlichen Verfahrensablauf gemäß den Fign. 1A bis 1D folgende Schritte notwendig:

- die Ausbildung eines vertikalen Profils in einer Schicht aus Polymermaterial durch reaktives Ionenätzen und die Abscheidung von Siliciumnitrid oder Siliciumdioxid aus einem Plasma (Fig. 1A);
- die Entfernung von Siliciumnitrid oder Siliciumdioxid von allen horizontalen Oberflächen durch reaktives Ionenätzen und die Entfernung des Polymermaterials unter Erhalt von Siliciumnitrid- oder Siliciumdioxidwänden (Fig. 1B);
- die Umwandlung der Siliciumnitrid- oder Siliciumdioxidwände in Öffnungen einer Maske in einem Umkehrverfahren durch Abscheidung des Maskenmaterials über den Siliciumnitrid-oder Siliciumdioxidwänden, Abtragen des Maskenmaterials durch Ätzen, bis die Spitzen der Siliciumnitrid- bzw. Siliciumdioxidwände freigelegt sind und Entfernen der Siliciumnitrid- bzw. Siliciumdioxidwände durch Plasmaätzen bzw. Naßätzen (Fig. 1C);
- das Öffnen der Maske bis zum Substrat (Fig. 1D).

Unter Verwendung der so hergestellten Maske werden Gräben durch reaktives Ionenätzen in daß Substrat aus Silicium geätzt, und das Maskenmaterial wird entfernt (Fig. 1E). Anschließend werden die Gräben durch thermische Oxidation mit Siliciumdioxid oder mit einem anderen Material gefüllt. Das Siliciumdioxid auf der Substratoberfläche wird durch reaktives Ionenätzen entfernt (Fig. 1F), und das Silicium wird reoxidiert zu einer Schichtdicke, die für weitere Prozesse erwünscht ist. Werden die Gräben mit Polyimid aufgefüllt, dann erfolgt dies im Anschluß an die Heißprozesse. Vor dem Auffüllen mit Polyimid 13 (Fig. 13) wird eine thermische Oxidation durchgeführt, bis die Grabenwände mit einer etwa 25 nm dicken Oxidschicht 11 bedeckt sind. Diese wird durch Abscheiden von etwa 50 nm Siliciumnitrid 12 versiegelt.

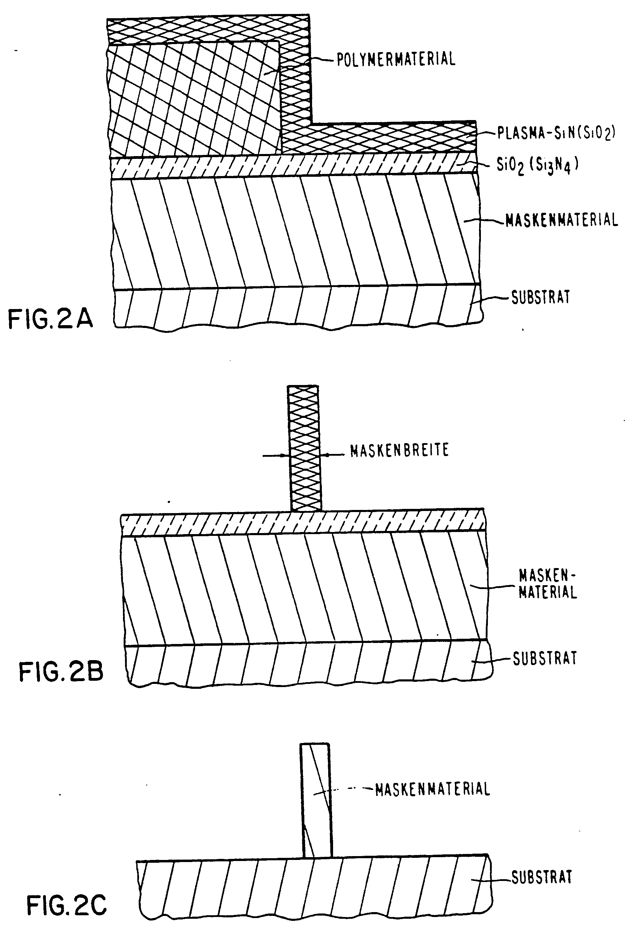

Zur Herstellung einer Maske aus einem anderen Maskenmaterial, aber mit gleichen Dimensionen, sind gemäß den Fign. 2A bis 2C folgende Schritte notwendig:

- wie zuvor beschrieben die Ausbildung eines vertikalen Profils in einer Schicht aus Polymermaterial und die Abscheidung von Siliciumnitrid oder Siliciumdioxid aus einem Plasma (Fig. 2A);
- die Entfernung von Siliciumnitrid bzw. Siliciumdioxid von allen horizontalen Oberflächen und die Entfernung des Polymermaterials unter Erhalt von Siliciumnitrid- oder Siliciumdioxidwänden (Fig. 2B);
- die Umwandlung der Maske gemäß Fig. 2B in eine Maske mit identischen Dimensionen, aber aus anderem Material (Fig. 2C) durch reaktives Ionenätzen und Strippen der Wände aus Siliciumnitrid bzw. Siliciumdioxid.

Anhand der Figuren 3 bis 9 und 14 und 15 wird allgemein das erfindungsgemäße Lithographieverfahren beschrieben und anschließend anhand eines speziellen Ausführungsbeispiels (Fign. 10 bis 13) die Herstellung einer tiefen dielektrischen Isolation in einem Siliciumhalbleiterkörper.

Gemäß Fig. 3 wird auf ein Siliciumhalbleitersubstrat eine Schicht 2 aus dielektrischem Material nach üblichen Verfahren aufgetragen. Die Schicht 2 kann beispielsweise aus Siliciumdioxid bestehen, welches durch thermische Oxidation bei 925°C erzeugt wird. Die Schicht 2 kann auch aus einer Siliciumdioxid- und einer Siliciumnitridschicht bestehen, wobei die Siliciumdioxidschicht eine Schichtdicke von etwa 160 nm und die Siliciumnitridschicht eine Schichtdicke von etwa 100 nm aufweist. Die Siliciumdioxidschicht wird in üblicher Weise durch thermische Oxidation erzeugt, und die Siliciumnitridschicht wird in bekannter Weise aus einer Silan, Ammoniak und Argon haltigen Atmosphäre bei einer Temperatur von etwa 1000°C niedergeschlagen. Anstelle der Siliciumdioxid-Siliciumnitrid-Doppelschicht kann auch eine Doppelschicht aus Siliciumdioxid und Polysilicium bzw. Polysilicium und Siliciumdioxid aufgetragen werden. Die Schicht 2 kann auch aus einer Schichtenfolge aufgebaut sein, auf die im einzelnen im Zusammenhang mit Fig. 14 eingegangen wird. Es ist auch möglich, die nun folgenden Schichten auf die blanke Oberfläche des Siliciumsubstrats 1 aufzutragen.

Auf die Schicht 2 wird zur Herstellung einer Struktur aus Polymermaterial mit vertikalen Seitenwänden ein Polymer, beispielsweise ein Polyimid, welches bis zu etwa 400 bis 450°C thermisch stabil ist, aufgesponnen. Es sei hervorgehoben, daß die Schichtdicke des Polymermaterials die Höhe der Siliciumnitrid- bzw. Siliciumdioxidwände, die im weiteren Verlauf des Verfahrens hergestellt werden, bestimmt. Als Polymermaterialien können auch eine Reihe bekannter positiver oder negativer Resistmaterialien in der gewünschten Schichtdicke, beispielsweise von etwa 2,0 μm aufgetragen werden. Als Positivresistmaterial kann beispielsweise ein Resist der Firma Shipley, der unter der Handelsbezeichnung 1350J erhältlich ist und aus einem Phenolformaldehydharz und einem Naphthochinondiazid-Sensibilisator besteht, welcher als 3,4-Dihydroxybenzophenon-4-[naphthochinon(1,2)diazid(2)]sulfonat identifiziert wird, verwendet werden. Die Resistschicht 3 wird bei einer Temperatur, welche gleich hoch oder höher ist als die Abscheidungstemperatur des Materials 6 zur Ausbildung der Seitenwandstruktur (Fig. 5) ausgehärtet. Die Resistschicht 3 aus dem zuvor genannten Material kann beispielsweise bei einer Temperatur von 210°C etwa 30 Minuten lang ausgehärtet werden. Auf die Resistschicht 3 wird als Ätzbarriere für das reaktive Ionenätzen mit Sauerstoff eine Siliciumnitridschicht 4 in einer Schichtdicke von etwa 100 nm aufgetragen. Das Siliciumnitrid wird durch Plasmaabscheidung aus einer Silan, Ammoniak und Argon haltigen Atmosphäre bei einem Druck von etwa 1 mbar und einer Leistung von 100 Watt (Leistungsdichte 0,05 W/cm²) niedergeschlagen. Die hierfür erforderliche Zeit beträgt etwa 3 bis 4 Minuten. Hervorzuheben ist, daß die Abscheidungstemperatur 210°C beträgt, d. h. es handelt sich um einen sog. "Kaltprozeß", bei dem das Material der Schicht 3 nicht geschädigt wird. In gleicher Weise kann anstelle der Siliciumnitridschicht 4 durch Plasmaabscheidung eine Schicht aus Siliciumdioxid oder eine Schicht aus Polysilicium auf die Resistschicht 3 aufgetragen werden. Im vorliegenden Fall wird auf die Plasma-Siliciumnitridschicht 4 eine Resistschicht 5 in einer Schichtdicke von etwa 1,0 μm aufgetragen. Die Schicht 5 kann aus dem gleichen Resistmaterial wie die Schicht 3 bestehen. Sie kann aber auch aus einem anderen, gegen Strahlung hochempfindlichen Photoresist, beispielsweise einem Methacrylatresist bestehen. In der Schicht 5 wird durch Belichten und Entwickeln ein Muster erzeugt. Anschließend wird, wie in Fig. 4 und SEM 1 gezeigt ist, durch reaktives Ionenätzen eine Resistmaske 3 mit möglichst steilen Kantenwinkeln erzeugt. Für die Herstellung der gewünschten Maskenstruktur mit möglichst steilen Kantenwinkeln ist Voraussetzung, daß diese Resistseitenwände so steil wie möglich sind.

Unter Verwendung der obersten Resistschicht 5 als Maske werden in die Plasmanitridschicht 4 Öffnungen geätzt. Die Nitridschicht 4 und die darunterliegende Polymer- bzw. Resistschicht 3 werden durch reaktive Ionen geätzt. Die Plasmanitridschicht 4 wird in einem Reaktor mit Kohlenstofftetrafluorid unter folgenden Bedingungen geätzt:

CF₄-Fluß : 30 cm³/Min.;
Druck : 50 μbar; (1 Bar = 10⁵ Pa)
Leistungsdichte : 0,2 Watt/cm².

Die Ätzrate für Plasmanitrid beträgt unter diesen Bedingungen etwa 30 nm/Min.
Die Schicht 4 mit den geätzten Öffnungen wird als Maske zum Ätzen der Resist- oder Polymerschicht 3 verwendet.
Die Schicht 3 wird in einem reaktiven Ionenätzverfahren mit Sauerstoff unter folgenden Bedingungen geätzt:

O₂-Fluß : 10 - 100 cm³/Min.;
Druck : 2 - 3 μbar;
Leistungsdichte : 0,2 Watt/cm².

Die Ätzrate für einen Resist beträgt unter diesen Bedingungen etwa 150 nm/Min. Um möglichst steile Resistseitenwände zu erhalten,

wird das reaktive Ionenätzen bei einem sehr niedrigem Sauerstoffdruck von etwa 2 bis 5 µbar durchgeführt. Würde man bei einem höheren Sauerstoffdruck arbeiten, dann würde der Anteil des lateralen Ätzens größer werden, welcher sich in einer seitlichen Unterätzung der Siliciumnitridmaske bemerkbar macht. Rückstände von Plasmanitrid und Resist werden in bekannter Weise durch Ätzen mit gepufferter Flußsäure entfernt. Im Zusammenhang mit dem zuvor beschriebenen Dreilagenprozeß zur Herstellung möglichst steiler Resistseitenwände wird auch auf die PCT Anmeldung WO 80/00639, Western Electric, US Priorität 11. September 1978 (Serial No. 941 369) verwiesen.

Die Struktur aus dem Polymermaterial 3 mit vertikalen Seitenwänden kann auch in einem modifizierten Bildumkehrprozeß (DE-Patent 2 529 054) hergestellt werden (nicht abgebildet). Dieses Verfahren ist kostengünstig und wenig aufwendig. Es resultieren ebenfalls Strukturen mit nahezu vertikalen Seitenwänden. Im einzelnen wird zur Herstellung eines zur Vorlage negativen Resistbildes eine lichtempfindliche Schicht, die ein Phenol-Formaldehydharz, ein o-Chinondiazid und ein 1-Hydroxyäthyl-2-alkyl-imidazolin (Monazoline C) enthält, auf das Substrat 1, 2 gemäß Fig. 3 aufgetragen. Diese Schicht wird bildmäßig belichtet und anschließend 10 bis 20 Minuten lang auf etwa 105° C erhitzt. Dabei findet in den belichteten Bereichen eine Vernetzung des Photoresists durch die Monazolinmoleküle statt, wodurch diese Bereiche in einem alkalischen Entwickler unlöslich werden. Nach der thermischen Behandlung wird die gesamte Photoresistschicht belichtet. Bei dieser ganzflächigen Belichtung wird der Photoresist nunmehr auch in den bei der bildmäßigen Belichtung nicht belichteten Bereichen zersetzt, während in den belichteten Bereichen keine wesentliche Veränderung mehr stattfindet. Nach dem Entwickeln in einem alkalischen Entwickler wird ein zur Vorlage negatives Resistbild erhalten.

Die Resiststruktur 3 auf dem Substrat 1, 2, welche nach dem Dreilagenprozeß (SEM 1) oder nach dem modifizierten Bildumkehrverfahren hergestellt wurde, dient zur Definition der Lage und der Höhe der in den folgenden Prozeßschritten heraustellenden Seitenwandmaske. In den Figuren 5 und 6 (SEM 2 und 3) ist die Plasmaabscheidung von Siliciumnitrid 6 auf den horizontalen und vertikalen Oberflächen der Resiststruktur 3 und des Substrats 2 gezeigt und die Herstellung von Plasmanitridwänden durch Entfernen des Nitrids von allen horizontalen Oberflächen durch reaktives Ionenätzen und, ebenfalls durch reaktives Ionenätzen, das Entfernen des Resists 3. Anstelle der Plasmaabscheidung von Nitrid können auf den horizontalen und vertikalen Oberflächen der Resist-Struktur auch Siliciumdioxid oder Polysilicium aus der Dampfphase bei niedriger Temperatur abgeschieden werden.

Gemäß Fig. 5 wird Siliciumnitrid 6 aus einem Plasma einer Silan, Ammoniak und Argon haltigen Atmosphäre bei einem Druck von 1 mbar und einer Leistung von 100 Watt bei einer Temperatur von 210° C in einer Schichtdicke von etwa 400 nm abgeschieden. Das Siliciumnitrid 6 bedeckt alle horizontalen und vertikalen Oberflächen der Resiststruktur 3 und des Substrats 2 (SEM 2). Anschließend wird das Siliciumnitrid von allen horizontalen Oberflächen durch reaktives Ionenätzen in Kohlenstofftetrafluorid entfernt. Hierzu arbeitet man beispielsweise bei einem $CF_4$-Fluß von 30 cm$^3$/Min., einem Druck von etwa 50 µbar und einer Leistungsdichte von 0,2 W/cm$^2$. Das Ätzen mit $CF_4$ wird unterbrochen, wenn alles Siliciumnitrid von den horizontalen Oberflächen entfernt ist. Die Endpunktsbestimmung der Ätzung erfolgt mit Laserinterferenz bei 5 bis 10 %-iger Überätzung. In analoger Weise wird verfahren, wenn das abgeschiedene Material aus Siliciumdioxid oder Polysilicium besteht. Der Resist 3 wird, wie zuvor beschrieben, durch reaktives Ionenätzen in einer sauerstoffhaltigen Atmosphäre entfernt. Die Einhaltung eines besonders niedrigen Sauerstoffdrucks ist bei diesem Schritt nicht erforderlich.

Gemäß Fig. 6 (SEM 3) bleiben nach den beiden zuvor genannten Ätzschritten etwa 250 nm dicke Siliciumnitridwände 6 zurück.

Im Falle der negativen Lithographie erfolgt jetzt die Abscheidung des eigentlichen Maskenmaterials (Fig. 7A). Als solches kommen beliebige Materialien, die durch Aufspinnen aufgetragen werden können in Frage, beispielsweise ein Photoresist, Polyimid oder Glas, oder Materialien, welche aufgesputtert oder aus der Dampfphase abgeschieden werden können, beispielsweise Siliciumdioxid, Siliciumnitrid, Magnesiumoxid, Polysilicium, Aluminiumoxid, Metalle und dergleichen. Wenn als Maskenmaterial Siliciumdioxid gewählt wird, kann dieses mittels Kathodenzerstäubung, durch Abscheidung aus einem Silan- und Sauerstoff-haltigen Gasplasma oder durch chemischen Niederschlag aus einer $SiH_4$ und Sauerstoff oder $SiH_2Cl_2$ und $N_2O$ haltigen Gasatmosphäre aufgebracht werden. Die verschiedenen Abscheidungsmethoden führen jeweils zu einer verschiedenen Form des Siliciumdioxids, welches die Plasmasiliciumnitridwände 6 bedeckt.

Gemäß Fig. 7A (SEM 4) werden die Siliciumnitridwände 6 beispielsweise mittels Kathodenzerstäubung mit Siliciumdioxid bedeckt. Dieses Verfahren ist das im Rahmen der vorliegenden Erfindung bevorzugte. Zunächst werden etwa 1,3 µm Siliciumdioxid (Standardquarz) im Standardverfahren mittels Kathodenzerstäubung aufgetragen. Anschließend wird eine etwa 0,5 µm dicke Siliciumdioxidschicht (Planarquarz) im Planarverfahren mittels Kathodenzerstäubung bei erhöhter Anodenleistung aufgetragen. Bei diesem Verfahren findet während des Auftragens gleichzeitig eine Abtragung von Siliciumdioxid statt, wodurch Strukturen mit einer Oberflächentopologie im wesentlichen planarisiert werden (Fig. 7A).

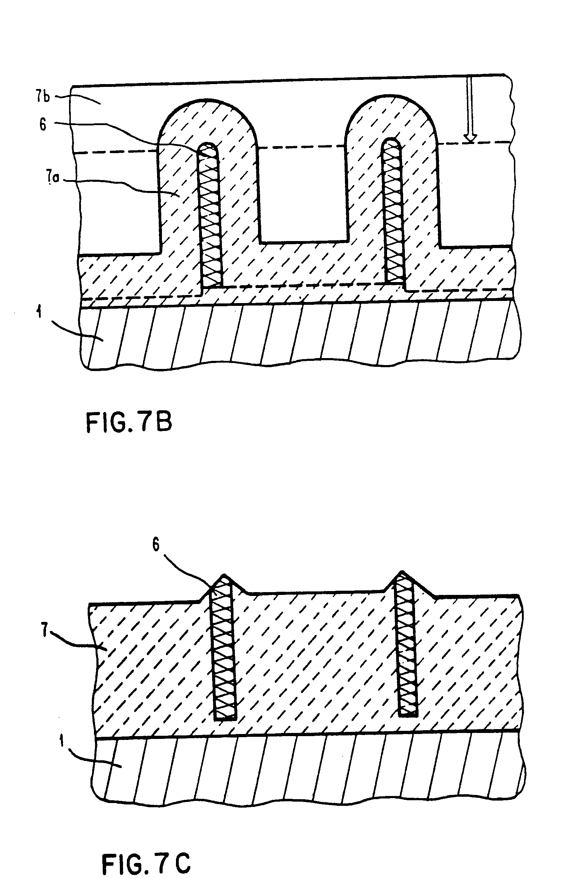

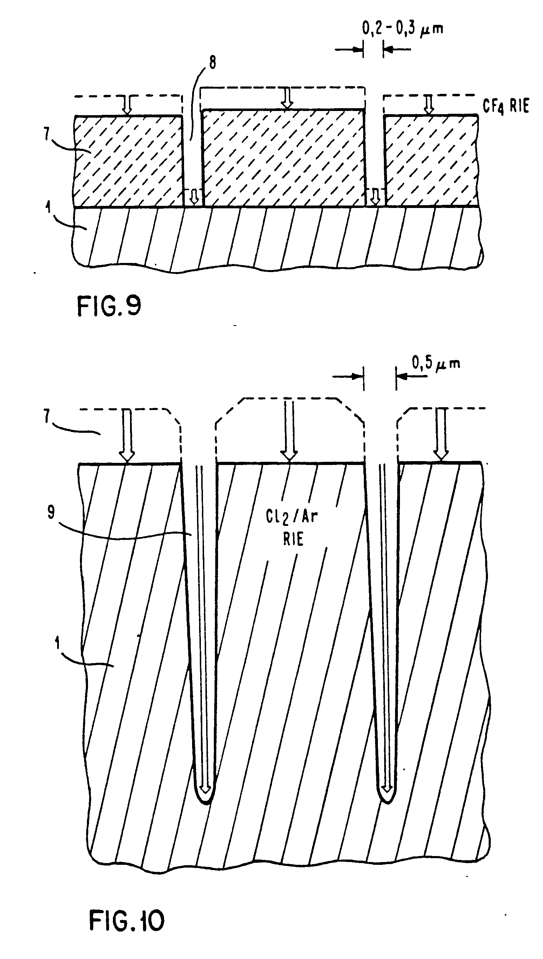

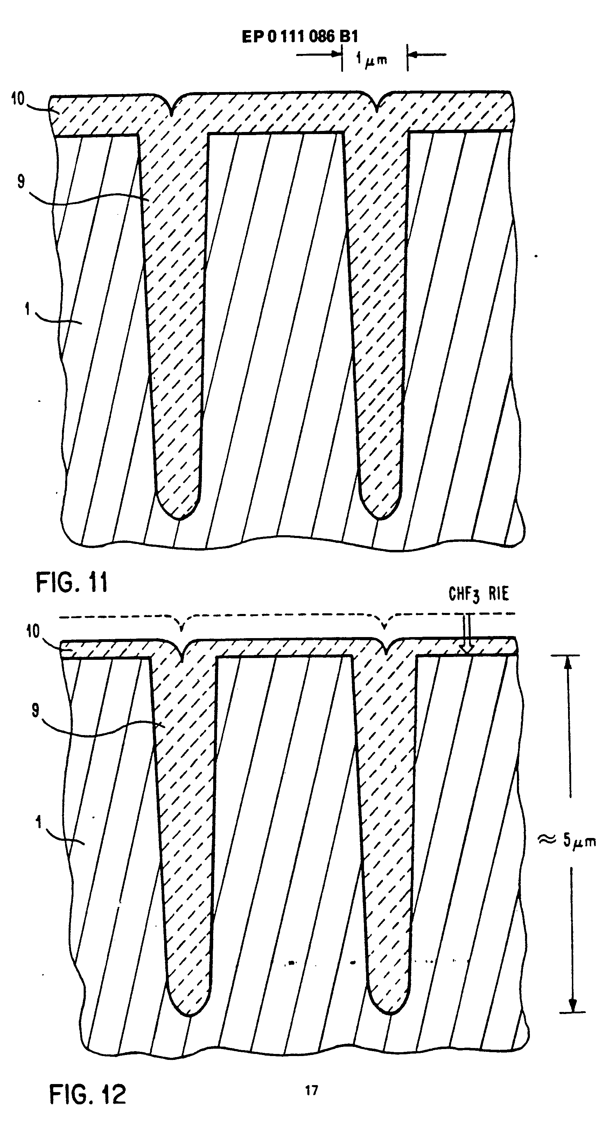

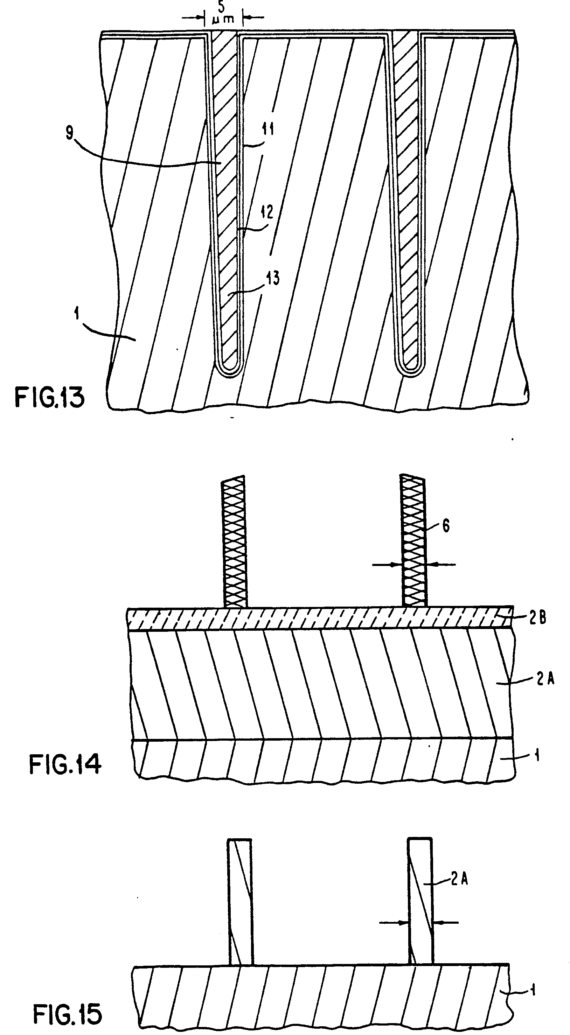

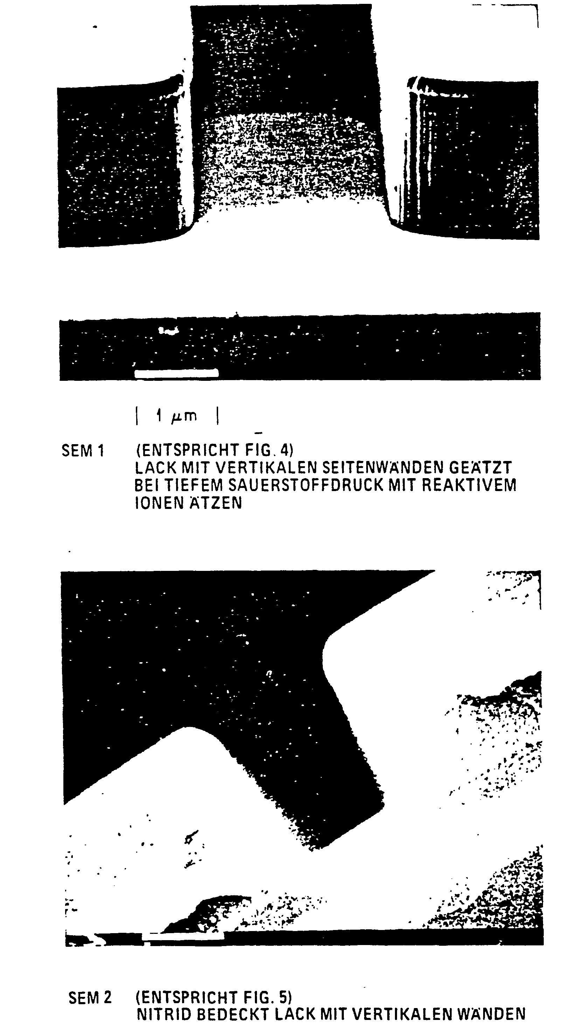

Weitere Möglichkeiten, die Siliciumnitridwände 6 mit Siliciumdioxid zu bedecken, sind in den Fign. 7B und 7C dargestellt. Gemäß Fig. 7B wird eine 0,5 μm dicke Siliciumdioxidschicht 7a mittels chemischen Niederschlags aus der Gasphase auf der gesamten Oberfläche der Struktur mit den Siliciumnitridwänden 6 abgeschieden. Das chemische Niederschlagen aus der Gasphase verwendet $SiH_4$ und $O_2$ bei etwa 500°C oder $SiH_2Cl_2$ und $N_2O$ bei etwa 800°C und Atmosphärendruck oder geringer. Anschließend wird mittels Kathodenzerstäubung eine etwa 1 μm dicke Siliciumdioxidschicht bei erhöhter Anodenleistung aufgetragen (Planarquarz). Während das aus der Gasphase abgeschiedene Siliciumdioxid 7a rund um die Wände gleichförmig aufwächst, bewirkt das mittels Kathodenzerstäubung aufgetragene Siliciumdioxid 7b eine Erhöhung der Siliciumdioxid-Schichtdicke und eine Planarisierung der Bereiche über den Siliciumnitridwänden 6 (Fig. 7B). Anstelle des Planarquarzes kann zur Planarisierung auch ein Photoresist als Schicht 7b aufgetragen und bei 180°C ausgehärtet werden.

Eine weitere Möglichkeit, eine Struktur gemäß Fig. 7 zu planarisieren, besteht darin, Quarz unter den üblichen Kathodenzerstäubungsbedingungen aufzutragen und zurückzuätzen, bis die Spitzen der Siliciumnitridwände 6 freigelegt sind (Fig. 7C). Eine Planarisierung der Struktur kann auch, wie bereits bei der Planarisierung gemäß Fig. 7B angedeutet, in der Weise durchgeführt werden, daß anstelle des mittels Kathodenzerstäubung aufgetragenen Quarzes ein Photoresist in einer Schichtdicke von 2,0 μm aufgetragen und bei 180°C ausgehärtet wird und anschliedend von der Resistschicht so viel abgeätzt wird, bis die Spitzen der Siliciumnitridwände freigelegt sind (Fig. 7C).

Im nächsten Verfahrensschritt werden gemäß Fig. 8 die in Siliciumdioxid als Maskenmaterial eingebetteten Siliciumnitridwände durch Ätzen entfernt. Zunächst wird das Siliciumdioxid ganzflächig in einer Schichtdicke von etwa 0,3 μm durch reaktives Ionenätzen mit $CF_4$ abgetragen. Anschließend werden die Siliciumnitridwände durch Plasmaätzen in einem System der LFE-Corporation mit Kohlenstofftetrafluorid bei einem Druck von etwa 1,0 mbar unter Erhalt von Öffnungen 8 mit einer Weite von 0,2 bis 0,3 μm, die bis zur $SiO_2$-Schicht 2 reichen, entfernt. Die Siliciumnitridwände können auch durch Naßätzen entfernt werden. Gemäß Fig. 9 werden die Öffnungen 8 der Siliciumdioxidmaske durch ganzflächiges reaktives Ionenätzen mit $CF_4$ durcb die Schicht 2 hindurch bis zum Siliciumsubstrat 1 hin vertieft. Dieser Schritt kann auch mit $CHF_3$-Gas durchgeführt werden, weil dadurch eine bessere Unterbrechung des Ätzens an der Siliciumsubstratoberfläche gewährleistet ist. Während des Ätzens wird auch Siliciumdioxid an der Oberfläche der Maske abgetragen. Wenn die Wände 6, die die Höhe und Breite der Maskenöffnungen 8 definieren, aus Siliciumdioxid oder Polysilicium hergestellt werden, muß zur Planarisierung ein Photoresist verwendet werden. Bei Wänden aus Polysilicium kann auch mit Quarz planarisiert werden. Die Siliciumdioxid- oder Polysiliciumwände 6 werden durch Naßätzen entfernt, bis die Schicht 2, die in diesem Fall aus Siliciumnitrid besteht, erreicht ist. In Fig. 9 (SEM 5) ist die fertiggestellte Ätzmaske aus Siliciumdioxid 7, die zum Ätzen von Gräben in Siliciumsubstrat 1 verwendet werden kann, gezeigt. Sie weist eine Dicke von etwa 0,6 bis 1 μm und Öffnungen mit nahezu vertikalen Seitenwänden und mit einer Breite von 0,2 bis 0,3 μm auf.

Bisher wurde ein Verfahren zur Herstellung einer Maske unter Anwendung der Seitenwandtechnologie beschrieben, bei dem eine zur Vorlage negative Maske erhalten wurde.

Ausgehend von Fig. 6 soll nunmehr anhand der Fign. 14 und 15 ein Verfahren beschrieben werden, mit dem die Seitenwände 6 in eine zur Vorlage positive Maske mit identischen Dimensionen, aber aus einem anderen Material umgewandelt werden kann. Gemäß Fig. 14 besteht die Schicht 2 der zuvor beschriebenen Figuren aus einer Doppelschicht, einer Schicht 2a aus dem gewünschten Maskenmaterial, beispielsweise aus einem Photoresist, aus Polyimid, Siliciumdioxid, Siliciumnitrid, Polysilicium, Metall oder Kombinationen dieser Materialien und einer dünnen, dielektrischen Schicht 2b, die auf der Schicht 2a angeordnet ist und aus Plasmanitrid oder Oxid besteht. An die Stelle der Schicht 2 kann auch eine Folge von Schichten, beispielsweise von Siliciumdioxid, Polyimid, Siliciumdioxid treten. Die Seitenwandstrukturen 6 mit den Submikrometerdimensionen werden, wie zuvor beschrieben, mit Hilfe einer Struktur aus Polymermaterial mit vertikalen Seitenwänden hergestellt. Die dielektrische Schicht 2b, die im Falle von Seitenwänden aus Plasmanitrid aus Siliciumdioxid besteht, wird durch reaktives Ionenätzen in Kohlenstofftetrafluorid entfernt. Die Schicht 2a wird in den von den Seitenwänden 6 nicht bedeckten Bereichen ebenfalls durch reaktives Ionenätzen entfernt. Wenn die Schicht 2a aus Polymermaterial besteht, kann das reaktive Ionenätzen in einer Atmosphäre von Sauerstoff durchgeführt werden. Anschließend werden die Seitenwandstrukturen 6 und das restliche Siliciumdioxid der Schicht 2b durch LFE-Ätzen oder Naßätzen entfernt. Es wird eine positive Maskenstruktur mit den Dimensionen der Plasmanitridsäulen gemäß Fig. 6 erhalten, die aber aus dem Material der Schicht 2a bestehen (Fign. 14 und 15).

Besteht die Schicht 2 von Fig. 14 aus einer Folge von Schichten von beispielsweise Siliciumdioxid, Polyimid, Siliciumdioxid, dann wird nach der Herstellung der Submikrometermaske 6 die oberste dünne Oxidschicht in CF$_4$-Atmosphäre, das Polyimid in Sauerstoffatmosphäre und das Siliciumdioxid auf der Oberfläche des Siliciumsubstrats in CF$_4$-Atmosphäre mit reaktiven Ionen geätzt. Durch Plasmaätzen in Sauerstoff oder durch Auflösen der mittleren Polyimidschicht der geätzten Strukturen wird die endgültige Maske aus Siliciumdioxid auf dem Siliciumsubstrat erhalten.

Nachfolgend wird eine spezielle Anwendung des zuvor beschriebenen Verfahrens aufgezeigt, bei dem in einem Maskenumkehrverfahren die Strukturen gemäß Fig. 6 zur Herstellung einer Siliciumdioxidmaske 7 verwendet werden.

Unter Verwendung dieser Maske werden Gräben in ein Siliciumsubstrat geätzt. Die Gräben werden durch thermische Oxidation aufgefüllt oder durch Aufspinnen eines Kunststoffs, beispielsweise von Polyimid. Als Siliciumsubstrat kann beispielsweise ein Halbleiterplättchen aus p-leitendem Material verwendet werden. Auf dieses Substrat mit einem spezifischen Widerstand von 10 Ω-cm, in dem eine N+ leitende Zone hergestellt wurde (nicht gezeigt), wird in einem üblichen Verfahren bei einer Temperatur im Bereich zwischen 950 und 1170° C und einer Dauer von etwa 17 Minuten eine N leitende Schicht mit einer maximalen Störelementkonzentration von 10$^{18}$ Atomen/cm$^3$ epitaktisch aufgewachsen. Während des Niederschlagens dieser Schicht findet eine Ausdiffusion der N+ leitenden Zone in diese Schicht hinein statt. Die Epitaxieschicht 1 (Fig. 3) hat eine Stärke in der Größenordnung zwischen 1 und 4 μm, entsprechend den übrigen Daten der integrierten Schaltung. Für die Zwecke der vorliegenden Erfindung wird eine Epitaxieschicht 1 mit einer Stärke von 2,35 μm angenommen, wobei die Epitaxieschicht 0,35 μm dicker ist als für übliche Prozesse, weil 0,35 μm Silicium durch Oxidation während der Durchführung des erfindungsgemäßen Verfahrens verbraucht werden. Die Epitaxieschicht 1 kann beispielsweise unter Verwendung einer Vorrichtung und eines Verfahrens aufgebracht werden, wie sie in der US-Patentschrift 3 424 629 beschrieben sind. Gemäß Fig. 3 wird dann eine Schicht 2 aus dielektrischem Material nach üblichen Verfahren auf die Epitaxieschicht 1 aufgetragen.

Gemäß der Prozeßübersicht anhand der Fign. 1A bis 1F und der speziellen Beschreibung sind zur Herstellung der Gräben und deren Ausfüllung folgende Schritte notwendig:

- Die Ausbildung eines vertikalen Profils aus Polymermaterial durch reaktives Ionenätzen und die Abscheidung von Siliciumnitrid oder Siliciumdioxid aus einem Plasma. Die Ausbildung des vertikalen Profils aus Polymermaterial erfolgt, wie bereits ausführlich abgehandelt, in einem Dreilagenprozeß (Fign. 3 und 4) oder in einem modifizierten Maskenumkehrprozeß. Die Abscheidung von Siliciumnitrid oder Siliciumdioxid aus einem Plasma auf allen horizontalen und vertikalen Oberflächen der Polymerstruktur (Fig. 5) erfolgt bei Temperaturen $\geqslant$ 200° C und $\leqslant$ 400° C. Durch diesen sog. Niedertemperaturprozeß werden die Strukturen aus Polymermaterial nicht geschädigt.

- Die Entfernung von Siliciumnitrid oder Siliciumoxid von allen horizontalen oberflächen erfolgt durch reaktives Ionenätzen in einer CF$_4$-haltigen Atmosphäre, und das Entfernen des Polymermaterials unter Erhalt von Siliciumnitrid- oder -oxidwänden erfolgt in einer sauerstoffhaltigen Atmosphäre. Einzelheiten des Verfahrens wurden anhand von Fig. 6 abgehandelt.

- Die Siliciumnitrid- oder -dioxidwände werden in einem Maskenumkehrverfahren in Öffnungen einer Maske umgewandelt durch Abscheiden des Maskenmaterials Siliciumdioxid über diesen Wänden, Abtragen des Siliciumdioxids durch Ätzen, bis die Spitzen der Wände freigelegt sind, und Entfernen der Siliciumnitrid- oder Siliciumdioxidwände durch Plasmaätzen. Das im Rahmen dieses Anwendungsbeispiels bevorzugte Verfahren zur Bedeckung der Siliciumnitridwände mit Siliciumdioxid ist das in der Beschreibung anhand von Fig. 7A abgehandelte Verfahren, bei dem zunächst etwa 1,3 μm Siliciumdioxid im Standardverfahren und anschließend etwa 0,5 μm Siliciumdioxid im Planarverfahren mittels Kathodenzerstäubung bei erhöhter Anodenleistung aufgetragen werden. Die Siliciumnitridwände werden nach dem Freilegen ihrer Spitzen durch Plasmaätzen mit Kohlenstofftetrafluorid entfernt, und anschließend werden die Öffnungen der Siliciumdioxidmaske durch ganzflächiges reaktives Ionenätzen mit Kohlenstofftetrafluorid bis zum Siliciumsubstrat hin vertieft. Diese Verfahrensschritte wurden anhand von Fig. 8 in der Beschreibung abgehandelt.

- In der Prozeßübersicht zeigt die Fig. 1E das Ätzen der tiefen Gräben in das Siliciumsubstrat und die Fig. 1F die Auffüllung der Gräben mit Siliciumdioxid bzw. Polyimid. Das Ätzen der Gräben in das Siliciumsubstrat und das Auffüllen derselben wird nachfolgend anhand der Fign. 10 bis 12 und der Sekundärelektronenmikroskop-Aufnahmen SEM 6 und 7 im einzelnen erläutert.

Fig. 10 (SEM 6) zeigt die Herstellung der Gräben 9 in dem Siliciumsubstrat 1 durch Ätzen. Das reaktive Ionenätzen, welches hierzu durchgeführt wird, findet unter folgenden Bedingungen statt:

Ätzmedium : 10 % Chlor, Rest Argon;
Fluß : 30 cm$^3$/Min.;
Druck : 15 mbar;
Leistung : 0,2 Watt/cm$^2$.

Unter diesen Bedingungen werden etwa 0,5 μm breite und 5 μm tiefe Gräben 9 in das Siliciumsubstrat 1 geätzt.

Andere Verfahren zum Ätzen von Silicium bedienen sich Gasmischungen mit einem Gehalt an $SF_6$, $Cl_2$ und Helium oder $CCl_2F_2$ und $O_2$ oder $SiF_4$, $Cl_2$, Helium oder Argon. Allgemein können chlor-, fluor- und/oder sauerstoffhaltige Gasgemische zum reaktiven Ionenätzen von Silicium verwenßet werden. In einem System mit 10 % $Cl_2$ in Argon werden in einem reaktiven Ionenätzer der Firma Leybold Ätzratenverhältnisse von Silicium zu Siliciumdioxid von bis zu 20 : 1 erhalten. Sollen gleichzeitig tiefe und flache Gräben geätzt werden, dann muß der zuvor beschriebene Ätzprozeß zweimal durchgeführt werden, oder es muß eine Abdeckmaske verwendet werden, mit der die flachen Gräben während des weiteren Ätzens der tiefen Gräben abgedeckt werden. Gemäß Fig. 10 wird die verbleibende Siliciumdioxid-Ätzmaske in einem Naßätzschritt mit gepufferter Flußsäure entfernt.

In Fig. 11 ist das Auffüllen der Gräben durch thermische Oxidation dargestellt. Diese erfolgt bei etwa 1000°C und wird als Trocken-Naß-Trocken-Oxidation durchgeführt, bis sich in den Gräben von jeder Grabenwandung aus etwa 0,5 μm Siliciumdioxid und auf der Oberfläche ein Siliciumdioxid vergleichbarer Schichtdicke gebildet hat. Die Oxidation kann auch in Form einer Hochdruckoxidation bei 850°C durchgeführt werden. Um eine Oxidschicht 10 auf der Siliciumsubstratoberfläche 1 (Fig. 12, SEM 7) in einer für die nachfolgenden Ätz- und Diffusionsprozesse erforderlichen Schichtdicke zu erhalten, wird daß Oxid in Fig. 11 durch ganzflächiges reaktives Ionenätzen in $CHF_3$ mit Unterbrechung der Ätzung an der Siliciumoberfläche entfernt. Anschließend wird das Silicium reoxidiert zu einer Schichtdicke von etwa 160 nm (Fig. 12). Anstelle des Auffüllens der Gräben durch thermische Oxidation kann auch folgendes Verfahren angewendet werden (Fig. 13):

a) thermische Oxidation zur Erzeugung von etwa 25 nm Siliciumdioxid 11;
b) Abscheiden von etwä 50 nm Siliciumnitrid 12 aus der Gasphase;
c) vollständiges Auffüllen der Gräben mit Polyimid 13, welches in bekannter Weise aufgesponnen wird.

Nachfolgend werden noch einmal die wesentlichen Merkmale und Vorteile des erfindungsgemäßen Verfahrens bei seiner Anwendung zur Herstellung tiefer dielektrischer Isolationen mit Submikrometerbreite angegeben:

- Es ist möglich, dielektrische Isolationen mit einer Breite von etwa 0,5 bis 1,0 μm herzustellen.
- Es können gleichzeitig tiefe und flache Isolationen, beispielsweise eine Subkollektorisolation mit einer Tiefe von 4 bis 5 μm und eine Basisisolation mit einer Tiefe von 1 μm hergestellt werden.
- Der Minimalabstand zwischen zwei Isolationen beträgt etwa 1,5 bis 2,0 μm.

- Die Grenzfläche zwischen der Isolation und dem Siliciumsubstrat weist aufgrund der thermischen Oxidation ein niedriges Ladungsniveau auf.
- Die Auffüllung der Gräben mit Polyimid anstelle der Auffüllung durch thermische Oxidation ist besonders vorteilhaft, weil bei völlig durch thermisches Oxid gefüllten Gräben Defekte im Silicium beobachtet wurden. Bei Auffüllung durch aus der Gasphase abgeschiedenem Oxid können solche Defekte weitestgehend vermieden werden.
- Das beschriebene Verfahren ist ein Planarprozeß, deshalb wird die Ausbildung der unerwünschten "Vogelköpfe" vermieden.
- Die Diffusionen von Subkollektor, Basis und Emitter können direkt an die Isolation anschließen, die Ausbildung der unerwünschten "Vogelschnäbel" wird ebenfalls vermieden. Im Falle der Auffüllung mit Polyimid werden die Gräben im Anschluß an die Diffusion von Subkollektor, Basis und Emitter geätzt.
- Die Qualität der mit dem erfindungsgemäßen Verfahren hergestellten Anordnungen ist verbessert aufgrund der niedrigeren Kapazität, welche auf das direkte Anschließen der Diffusionen an die Isolationen und kürzere elektrische Leitungswege zurückzuführen ist.
- Aus der geringen Breite der Isolationen und den direkt daran anschließenden Diffusionen resultiert eine höhere Integrationsdichte.

Das erfindungsgemäße Verfahren zum Herstellen von Strukturen mit Abmessungen im Submikrometerbereich verwendet anstelle von dielektrischen Materialien Polymermaterialien zur Definition von Strukturen mit horizontalen und vertikalen Oberflächen, beispielsweise einen Photoresist oder Polyimid. Die Polymermaterialien können in einem einfachen und billigen Verfahren durch Aufspinnen, aufgetragen werden. Sie lassen sich, insbesondere unter Anwendung des beschriebenen Dreilagenprozesses, mit reaktiven Sauerstoffionen in hervorragender Weise senkrecht ätzen. Die Polymerschicht, die die Position und die Dicke der Maske bestimmt, läßt sich mit einer wesentlich größeren Schichtdicke auftragen als beispielsweise dielektrische Materialien. Daher können Masken mit einer größeren Dicke, als mit anderen Prozessen möglich wäre, hergestellt werden. Mit Masken, die eine Dicke von beispielsweise bis zu 3 μm haben, können bis zu 6 μm tiefe Gräben in ein Siliciumsubstrat geätzt werden. Die Herstellung der Seitenwandstrukturen aus Siliciumdioxid oder Siliciumnitrid erfolgt in einem Plasmaabscheidungsverfahren, welches bei Temperaturen ≥ 200°C durchgeführt werden kann und einen sog. Niedertemperaturprozeß darstellt, so daß keine Schädigung der Polymerstrukturen stattfindet. Die im Vergleich mit dem Stand der Technik niedrigeren Prozeßtemperaturen gestatten darüber hinaus eine universellere Anwendbarkeit des Verfahrens. Das erfindungsgemäße Verfahren ist nicht nur zur Herstellung von tiefen dielektrischen Isolationen mit einer Grabenbreite im Submikrometerbereich geeignet. Weitere Anwendungsmöglichkeiten sind beispielsweise die Herstellung von Feldeffekttransistoren mit einer Kanallänge im Submikrometerbereich oder die Herstellung von lateralen, bipolaren pnp-Transistoren mit einer Basisbreite im Submikrometerbereich.

## Patentansprüche

1. Verfahren zum Herstellen von Strukturen mit Abmessungen im Submikrometerbereich in einer auf einem Siliciumsubstrat angeordneten Schicht,

dadurch gekennzeichnet,

a) daß zunächst auf das Siliciumsubstrat (1) eine erste Isolierschicht (2; Fig. 3) oder eine Folge von Schichten (2a, 2b; Fig. 14) aufgebracht wird;

b) daß auf die Schicht (2, 2b) eine Polymerschicht (3) aufgebracht wird und Teile dieser Schicht wieder entfernt werden unter Ausbildung von Polymerstrukturen (3), die neben horizontalen Oberflächen an ihren Rändern im wesentlichen vertikale Oberflächen aufweisen (Fig. 4);

c) daß auf die horizontalen und im wesentlichen vertikalen Oberflächen der Polymerstrukturen sowie auf die freigelegten horizontalen Bereiche der ersten Isolierschicht (2, 2b) eine zweite Isolierschicht (6) aufgebracht wird (Fig. 5);

d) daß die horizontalen Bereiche der zweiten Isolierschicht (6) sowie die Polymerstruktur (3) durch reaktives Ionenätzen in der Weise abgetragen werden, daß sehr schmale Wände der zweiten Isolierschicht (6) auf der ersten Isolierschicht (2) verbleiben (Fig. 6);

e1) daß im Falle positiver Lithographie die Wände direkt als Maske zur Ausbildung von Strukturen in der Schicht (2a; Fig. 14) mit Abmessungen im Submikrometerbereich dienen und

e2) daß im Falle negativer Lithographie die Wände in das eigentliche Maskenmaterial (7) eingebettet werden, das zur Erzielung einer verbesserten Oberflächenplanarität teilweise wieder abgetragen wird (Fig. 7A);

-f) daß die in das Maskenmaterial (7) eingebetteten Wände aus dem zweiten Isolierstoff (6) durch Ätzen entfernt werden unter Erhalt von Maskenöffnungen (8) mit Abmessungen im Submikrometerbereich, die durch reaktives Ionenätzen noch bis zum Substrat (1) hin vertieft werden (Fig. 8).

2. Verfahren nach Anspruch 1,

dadurch gekennzeichnet,

daß zur Herstellung der Polymerstrukturen (3) mit horizontalen und an ihren Rändern im wesentlichen vertikalen Oberflächen Schichten (3, 4 und 5) auf die Isolierschicht (2) aufgebracht werden (Fig. 3), wobei die auf die Isolierschicht (2) direkt aufgebrachte Polymerschicht (3) aus Polyimid oder einem Photoresist, die Schicht (4) aus Plasmasiliciumnitrid oder -oxid und die Schicht (5) aus einem Photoresist bestehen;

daß das gewünschte Muster in der obersten Schicht (5) erzeugt wird und durch reaktives Ionenätzen in die Plasmanitridschicht (4) bzw. in die Polymerschicht (3) übertragen wird (Fig. 4).

3. Verfahren nach den Ansprüchen 1 und 2,

dadurch gekennzeichnet,

daß von den Schichten (3, 4 und 5) die Schicht (3) aus einem Positivphotoresist besteht und eine Schichtdicke im Bereich von 1,0 $\mu$m bis 2,0 $\mu$m aufweist, die nächste Schicht (4) aus Plasmasiliciumnitrid besteht und eine Schichtdicke im Bereich von 0,2 $\mu$m bis 0,5 $\mu$m aufweist und die oberste Schicht (5) aus einem hochempfindlichen Photoresist besteht und eine Schichtdicke im Bereich von 0,5 $\mu$m bis 1,5 $\mu$m aufweist.

4. Verfahren nach den Ansprüchen 1 bis 3,

dadurch gekennzeichnet,

daß das Muster von der Schicht (5) durch reaktives Ionenätzen mit $CF_4$ in die Schicht (4) aus Plasmanitrid und durch reaktives Ionenätzen mit Sauerstoff bei einem Druck unterhalb 5 $\mu$bar in die Resistschicht (3) übertragen wird.

5. Verfahren nach Anspruch 1,

dadurch gekennzeichnet,

daß zur Herstellung von Polymerstrukturen (3) mit horizontalen und an ihren Rändern im wesentlichen vertikalen Oberflächen ein modifizierter Bildumkehrprozeß angewendet wird, bei dem eine lichtempfindliche Schicht aus einem Positivphotoresist mit einem Gehalt an 1-Hydroxyäthyl-2-alkyl-imidazolin auf ein Substrat (1, 2) aufgetragen, bildmäßig belichtet, bei 105°C 10 bis 20 Minuten ausgehärtet, dann ganzflächig belichtet und in einem alkalischen Entwickler entwickelt wird, wobei ein zur Vorlage negatives Resistbild mit im wesentlichen vertikalen Seitenwänden erhalten wird.

6. Verfahren nach Anspruch 1,

dadurch gekennnzeichnet,

daß auf dem Siliciumsubstrat (1) als erste Isolierschicht (2) mittels thermischer Oxidation eine Siliciumdioxidschicht oder mittels Abscheidung aus einer Silan, Ammoniak und Argon haltigen Atmosphäre eine Siliciumnitridschicht oder eine Doppelschicht aus Siliciumdioxid und Siliciumnitrid erzeugt wird.

7. Verfahren nach den Ansprüchen 1 und 6,

dadurch gekennzeichnet,

daß im Falle von Siliciumdioxid als erster Isolierschicht auf die horizontalen und im wesentlichen vertikalen Oberflächen der Polymerstruktur (3) und die horizontale Oberfläche der ersten Isolierschicht (2) Plasmasiliciumnitrid oder Polysilicium als zweite Isolierschicht (6) und im Falle von Siliciumnitrid als erster Isolierschicht Plasmasiliciumdioxid als zweite Isolierschicht aufgetragen werden.

8. Verfahren nach Anspruch 1,

dadurch gekennzeichnet,

daß Siliciumnitrid (6) auf die horizontalen und im wesentlichen vertikalen Oberflächen der Reststruktur (3) und der Isolierschicht (2) durch Plasmaabscheidung aus einer Silan, Ammoniak und Argon haltigen Atmosphäre bei einem Druck von etwa 1 mbar, einer Leistung von 100 Watt (Leistungsdichte von 0,05 Watt/cm$^2$) und einer Temperatur von 210°C aufgetragen wird.

9. Verfahren nach den Ansprüchen 1 und 8, dadurch gekennzeichnet,

daß die horizontalen Bereiche der Siliciumnitridschicht (6) durch reaktives Ionenätzen mit CF$_4$ und die Reststruktur (3) durch reaktives Ionenätzen mit Sauerstoff abgetragen werden.

10. Verfahren nach Anspruch 1, dadurch gekennzeichnet,

daß im Falle positiver Lithographie die Schicht (2a; Fig. 14) aus dem gewünschten Maskenmaterial aus der Gruppe von einem Polymermaterial wie Photoresist, Polyimid, oder aus anorganischem Material wie SiO$_2$, Si$_3$N$_4$, Polysilicium, Metall oder Kombinationen derselben besteht und eine dünne dielektrische Schicht (2b) aus Plasmanitrid oder Oxid auf der Schicht (2a) angeordnet ist.

11. Verfahren nach den Ansprüchen 1 und 10, dadurch gekennzeichnet,

daß die dielektrische Schicht (2b) und die Schicht (2a) in den von der Seitenwandmaske (6) nicht bedeckten Bereichen durch reaktives Ionenätzen entfernt und anschließend die Seitenwandmaske und die darunter verbliebenen Reste der dielektrischen Schicht (2b) abgeätzt werden unter Erhalt einer Maske mit den Dimensionen der Vorlage, aber aus dem Material der Schicht (2b; Fig. 15).

12. Verfahren nach Anspruch 1, dadurch gekennzeichnet,

daß im Falle negativer Lithographie auf das Substrat (1, 2) mit den Seitenwänden (6) Maskenmaterialien (7) aus der Gruppe von Polymermaterialien wie Photoresist oder Polyimid oder Glas aufgesponnen werden, oder Materialien wie SiO$_2$, Si$_3$N$_4$, MgO, Polysilicium oder Al$_2$O$_3$ oder Metalle aufgesputtert oder durch chemische Abscheidung aus der Gasphase aufgebracht werden.

13. Verfahren nach den Ansprüchen 1 und 12, dadurch gekennzeichnet,

daß auf das Substrat (1, 2) mit Seitenwänden (6) aus Siliciumnitrid als Maskenmaterial (7) Siliciumdioxid mittels Kathodenzerstäubung aufgebracht wird, wobei eine erste, etwa 1,0 μm dicke Schicht unter üblichen Bedingungen und eine zweite, etwa 0,5 μm dicke Siliciumdioxidschicht mit erhöhter Anodenleistung zur Erzielung einer verbesserten Oberflächenplanarität aufgebracht wird.

14. Verfahren nach den Ansprüchen 1 und 12, dadurch gekennzeichnet,

daß man eine etwa 0,5 μm dicke Siliciumdioxidschicht (7a) mittels chemischen Niederschlags aus der Gasphase gleichförmig rund um die Siliciumnitridwände (6) aufwachsen läßt und daß anschließend mittels Kathodenzerstäubung eine etwa 1 μm dicke Siliciumdioxidschicht (7b) bei erhöhter Anodenleistung aufgebracht wird zur Erhöhung der Siliciumdioxid-Schichtdicke und zur Erzielung einer verbesserten Oberflächenplanarität.

15. Verfahren nach Anspruch 14, dadurch gekennzeichnet,

daß anstelle der Siliciumdioxidschicht (7b) oder der Siliciumdioxidschichten (7a und 7b) zur Oberflächenplanarisierung eine Photoresistschicht aufgesponnen und zurückgeätzt wird.

16. Verfahren nach Anspruch 1, dadurch gekennzeichnet,

daß zur Entfernung der Seitenwände (6) die Siliciumdioxidschicht (7) bzw. die Photoresistschicht ganzflächig durch reaktives Ionenätzen abgetragen wird, bis die Spitzen der Seitenwände (6) freigelegt sind und daß anschließend das Siliciumnitrid oder Oxid durch Plasmaätzen oder durch Naßätzen entfernt wird und daß die Öffnungen (8) bis zur Oberfläche des Siliciumsubstrats (1) durch ganzflächiges reaktives Ionenätzen vertieft werden.

17. Verfahren nach Anspruch 16, dadurch gekennzeichnet,

daß nach dem Abtragen der Siliciumdioxidschicht (7) die Siliciumnitridwände durch Plasmaätzen mit CF$_4$ entfernt werden und die Öffnungen (8) bis zur Oberfläche des Siliciumsubstrats (1) durch ganzflächiges reaktives Ionenätzen mit CF$_4$ vertieft werden.

18. Verfahren gemäß einem oder mehreren der Ansprüche 1 bis 17 in seiner Anwendung zur Herstellung einer tiefen dielektrischen Isolation mit Submikrometerbreite (9) in einem Siliciumkörper (1), dadurch gekennzeichnet,

daß durch die fertiggestellte Maske (7) Gräben (9) in das Siliciumsubstrat (1) durch reaktives Ionenätzen mit Chlor und/oder sauerstoffhaltigen Gasen geätzt werden (Fig. 10);

daß die Gräben (9) durch thermische Oxidation allein (Fig. 11), oder mit thermischem Oxid (11), Nitrid (12) und einem Kunststoff (13; Fig. 13) aufgefüllt werden;

und daß im Falle des Füllens durch thermische Oxidation allein nach dem ganzflächigen Abätzen des Oxids von der Oberfläche des Siliciumkörpers (1) eine Reoxidation unter Erhalt einer Siliciumdioxidschicht (10) vorgenommen wird (Fig. 12).

19. Verfahren nach Anspruch 18, dadurch gekennzeichnet,

daß die Gräben (9) in dem Siliciumsubstrat (1) mittels reaktiven Ionenätzens mit Chlor/Argon; SF$_6$/Chlor/Helium; CCl$_2$F$_2$/Sauerstoff oder SiF$_4$/Chlor/Helium oder Argon-Gasgemischen durch die Siliciumdioxidmaske (7) hergestellt werden.

20. Verfahren nach den Ansprüchen 18 und 19, dadurch gekennzeichnet,

daß bei der gleichzeitigen Herstellung von tiefen und flachen Gräben die flachen Gräben während des weiteren Ätzens der tiefen Gräben abgedeckt werden.

21. Verfahren nach den Ansprüchen 18 bis 20, dadurch gekennzeichnet, daß die Gräben durch thermische Oxidation mit Siliciumdioxid aufgefüllt werden (Fig. 11), oder eine thermische Oxidation zur Erzeugung von etwa 25 nm Siliciumdioxid (11), eine Abscheidung von etwa 50 nm Siliciumnitrid (12) aus der Gasphase vorgenommen und die Gräben dann vollständig mit Polyimid (13) aufgefüllt werden (Fig. 13).

22. Verfahren nach den Ansprüchen 18 und 21, dadurch gekennzeichnet, daß im Falle des Füllens der Gräben durch thermische Oxidation das Oxid auf der Siliciumsubstratoberfläche (1) durch ganzflächiges reaktives Ionenätzen mit CHF₃ entfernt und anschließend das Siliciumsubstrat (1) reoxidiert wird zu einer für die nachfolgenden Prozesse erforderlichen Oxidschichtdicke (10).

**Claims**

1. Method of making structures with dimensions in the sub-micrometer range in a layer arranged on a silicon substrate, characterized in that

a) first, a first isolating layer (2; Fig. 3) or a sequence of layers (2a, 2b; Fig. 14) is applied on a silicon substrate (1);

b) that onto the layer (2, 2b) a polymeric layer (3) is applied, and parts of this layer are removed again, forming polymeric structures (3) which beside horizontal surfaces show substantially vertical surfaces at their edges (Fig. 4);

c) that on the horizontal and substantially vertical surfaces of the polymeric structures, as well as on the exposed horizontal regions of the first isolating layer (2, 2b) a second isolating layer (6) is applied (Fig. 5);

d) that the horizontal regions of the second isolating layer (6), as well as the polymeric structure (3) are removed by reactive ion etching in such a manner that very narrow walls of the second isolating layer (6) remain on the first isolating layer (2) (Fig. 6);

e1) that in the case of positive lithography the walls directly serve as a mask for forming structures in the layer (2a; Fig. 14) with dimensions in the submicrometer range, and

e2) that in the case of negative lithography the walls are embedded in the desired mask material (7) which for obtaining an improved surface planarity is partly removed again (Fig. 7A);

f) that the walls of the second isolating material (6) embedded in the mask material (7) are removed by etching, with resulting mask openings (8) with dimensions in the submicrometer range which are extended by reactive ion etching to the substrate (1) (Fig. 8).

2. Method as claimed in claim 1, characterized in that for making the polymeric structures (3) with horizontal and at their edges substantially vertical surfaces layers (3, 4 and 5) are applied on the isolating layer (2) (Fig. 3) with the polymeric layer (3) directly applied on the isolating layer (2) consisting of polyimide, or of a photoresist, and the layer (4) of plasma silicon nitride or oxide, and the layer (5) of a photoresist;

that the desired pattern is made in the top layer (5) and transferred by reactive ion etching into the plasma nitride layer (4) and into the polymeric layer (3) respectively (Fig. 4).

3. Method as claimed in claims 1 and 2, characterized in that of the layers (3, 4 and 5) the layer (3) consists of a positive photoresist and is between 1.0 μm and 2.0 μm thick, that the next layer (4) consists of plasma silicon nitride and is between 0.2 μm and 0.5 μm thick, and that the top layer (5) consists of a highly sensitive photoresist and is between 0.5 μm to 1.5 μm thick.

4. Method as claimed in any one of claims 1 to 3, characterized in that the pattern is transferred from the layer (5) by reactive ion etching with CF₄ into the layer (4) of plasma nitride, and by reactive ion etching with oxygen at a pressure of less than 5 μbar into the resist layer (3).

5. Method as claimed in claim 1, characterized in that for making polymeric structures (3) with horizontal and that their edges, substantially vertical surfaces a modified image reversal process is applied where a photosensitive layer of a positive photoresist containing 1-hydroxyethyl-2-alkyl-imidazoline is applied on a substrate (1, 2), exposed image-wise cured at 105°C for 10 to 20 minutes, then blanket-exposed and developed in an alkaline developer, with a resist image negative relative to the original pattern and having substantially vertical sidewalls resulting.

6. Method as claimed in claim 1, characterized in that on the silicon substrate (1) as a first isolating layer (2) a silicon dioxide layer is produced by means of thermal oxidation, or a silicon nitride layer by means of deposition out of a silane, ammonia and argon-containing atmosphere, or a double layer of silicon dioxide and silicon nitride.

7. Method as claimed in any one of claims 1 and 6, characterized in that in the case of silicon dioxide as first isolating layer plasma silicon nitride or polysilicon (6) are deposited as second isolating layer on the horizontal and substantially vertical surfaces of the polymeric structure (3) and the horizontal surface of the first isolating layer (2) and in the case of silicon nitride as the first isolating layer plasma silicon dioxide is deposited as the second isolating layer.

8. Method as claimed in claim 1, characterized in that silicon nitride (6) is deposited on the horizontal and substantially vertical surfaces of the resist structure (3) and the isolating layer (2) by plasma deposition out of an atmosphere containing silane, ammonia and argon, at a pressure of approximately 1 μbar, an energy of 100 Watt (energy density of 0.05 Watt/cm²) and a temperature of 210°C.

9. Method as claimed in any one of claims 1 and 8, characterized in that the horizontal regions of the silicon nidride layer (6) are removed by reactive ion etching with CF$_4$, and the resist structure (3) by reactive ion etching with oxygen.

10. Method as claimed in claim 1, characterized in that in the case of positive lithography layer (2a; Fig. 14) consists of the desired mask material selected from the group of a polymeric material such as photoresist, polyimide, or of inorganic material such as SiO$_2$, Si$_3$N$_4$, polysilicon, metal, or combinations thereof, and that a thin dielectric layer (2b) of plasma nitride or oxide is arranged on the layer (2a).

11. Method as claimed in any one of claims 1 and 10, characterized in that the dielectric layer (2b) and the layer (2a) is removed in the regions not covered by the sidewall mask (6) by means of reactive ion etching, and that subsequently the sidewall mask and the remains of the dielectric layer (2b) therebeneath are etched off, with a mask with the dimensions of the original pattern, but consisting of the material of the layer (2b; Fig. 15) resulting.

12. Method as claimed in claim 1, characterized in that in the case of negative lithography onto the substrate (1, 2) with the sidewalls (6) mask materials (7) of the group of polymeric materials as photoresist or polyimide or glass are spin-coated, or materials as SiO$_2$, Si$_3$N$_4$, MgO, polysilicon or Al$_2$O$_3$ or metals are applied by sputtering, or by chemical vapor deposition.

13. Method as claimed in any one of claims 1 and 12, characterized in that onto the substrate (1, 2) with sidewalls of silicon nitride silicon dioxide is deposited as mask material (7) by means of cathode sputtering, a first, approximately 1.3 µm thick layer being applied under the usual conditions, and a second, approximately 0.5 µm thick silicon dioxide layer being deposited with increased anode efficiency to achieve an improved surface planarity.

14. Method as claimed in any one of claims 1 and 12, characterized in that an approximately 0.5 µm thick silicon dioxide layer (7a) is chemically vapor deposited uniformly round the silicon nitride walls (6), and that subsequently by means of cathode sputtering an approximately 1 µm thick silicon dioxide layer (7b) is deposited with increased anode efficiency to increase the silicon dioxide layer thickness, and to achieve an improved surface planarity.

15. Method as claimed in claim 14, characterized in that instead of the silicon dioxide layer (7b) or the silicon dioxide layers (7a and 7b) a photoresist layer is spun-on and etched back for surface planarization.

16. Method as claimed in claim 1, characterized in that for removing the sidewalls (6) the silicon dioxide layer (7) or the photoresist layer, respectively, is blanket removed by reactive ion etching until the peaks of the sidewalls (6) are exposed, and that subsequently the silicon nitride or oxide is removed by plasma etching or wet etching, and that the openings (8) are extended to the surface of the silicon substrate (1) by blanket reactive ion etching.

17. Method as claimed in claim 16, characterized in that following the removal of the silicon dioxide layer (7) the silicon nitride walls are removed by plasma etching with CF$_4$, and that the openings (8) are extended to the surface of the silicon substrate (1) by blanket reactive ion etching with CF$_4$.

18. Method as claimed in one or several of claims 1 to 17 in its application to making a deep dielectric isolation with submicrometer width (9) in a silicon body (1), characterized in that
through the finished mask (7) trenches (9) are etched into the silicon substrate (1) by reactive ion etching with chlorine and/or oxygen-containing gases (Fig. 10);
that the trenches (9) are filled by thermal oxidation exclusively (Fig. 11), or with thermal oxide (11), nitride (12) and a synthetic material (13; Fig.13);
and that if filling takes place by thermal oxidation exclusively the blanket etching of the oxide off the surface of the silicon body (1) is followed by a reoxidation, with a silicon dioxide layer (10) resulting (Fig. 12).

19. Method as claimed in claim 18, characterized in that the trenches (9) in the silicon substrate (1) are made by reactive ion etching with chlorine/argon; SF$_6$/chlorine/helium; CCl$_2$F$_2$/oxygen or SiF$_4$/chlorine/helium or argon gas mixtures through the silicon dioxide mask (7).

20. Method as claimed in any one of claims 18 and 19, characterized in that if deep and shallow trenches are made simultaneously, the shallow trenches are covered during the additional etching of the deep trenches.

21. Method as claimed in any one of claims 18 to 20, characterized in that the trenches are filled by thermal oxidation with silicon dioxide (Fig. 11), or that a thermal oxidation to produce approximately 25 nm silicon dioxide (11), a vapor deposition to produce approximately 50 nm silicon nitride (12) are performed, and that the trenches are then completely filled with polyimide (13) (Fig. 13).

22. Method as claimed in any one of claims 18 and 21, characterized in that if the trenches are filled by thermal oxidation the oxide is removed from the silicon substrate surface (1) by blanket reactive ion etching with CHF$_3$, and that subsequently the silicon substrate (1) is reoxidized to an oxide layer thickness (10) required for the subsequent processes.

**Revendications**

1. Procédé de fabrication de structures de dimensions sub-micrométriques dans une couche disposée sur un substrat de silicium, caractérisé en ce que,
   a) on applique d'abord sur le substrat de silicium (1) une première couche isolante (2; figure 3) ou une série de couches (2a, 2b; figure 14);

b) on applique sur la couche (2, 2b) une couche de polymère (3) et l'on retire de nouveau des parties de cette couche avec formation de structures polymères (3) qui présentent à côté de surfaces horizontales à leurs bords des surfaces sensiblement verticales (figure 4);

c) on applique une seconde couche isolante (6) aux surfaces horizontales et sensiblement verticales des structures polymères, ainsi qu'aux zones horizontales dégagées de la première couche isolante (2, 2b) (figure 5);

d) on retire les zones horizontales de la seconde couche isolante (6), ainsi que la structure polymère (3), par corrosion ionique réactive, de telle façon qu'il reste sur la première couche isolante (2) des parois très étroites de la seconde couche isolante (6) (figure 6);

e1) dans le cas de la lithographie positive, les parois servent directement de masque pour la formation de structures dans la couche (2a; figure 14) de dimensions sub-micrométriques, et

e2) dans le cas de la lithographie négative, on incorpore les parois dans la matière de masque (7) elle-même, que l'on retire de nouveau partiellement pour obtenir un caractère planaire amélioré de la surface (figure 7A);

f) on retire les parois incorporées dans la matière de masque (7) de la seconde couche isolante (6) par corrosion, en obtenant des ouvertures de masque (8) de dimensions sub-micrométriques que l'on approfondit encore jusqu'au substrat (1) par corrosion ionique réactive (figure 8).

2. Procédé selon la revendication 1, caractérisé en ce que, pour produire les structures polymères (3) on applique sur la couche isolante (2) des couches (3, 4 et 5) à surfaces horizontales et sensiblement verticales à leurs bords (figure 3), la couche polymère (3) appliquée directement à la couche isolante (2) étant constituée par un polyimide ou un vernis photosensible, la couche (4) par du nitrure de silicium ou de l'oxyde de silice plasmatique, et la couche (5) par un vernis photosensible; et en ce qu'on produit le dessin souhaité dans la couche supérieure (5) et on le transfère par corrosion ionique réactive dans la couche de nitrure plasmatique (4) ou dans la couche polymère (3) (figure 4).

3. Procédé selon les revendications 1 et 2, caractérisé en ce que, parmi les couches (3, 4 et 5), la couche (3) est constituée par un vernis photosensible positif et présente une épaisseur de couche comprise entre 1,0 µm et 2,0 µm, la couche (4) suivante est constituée par du nitrure de silicium plasmatique et présente une épaisseur de couche comprise entre 0,2 µm et 0,5 µm, et la couche supérieure (5) est constituée par un vernis photosensible très sensible et présente une épaisseur de couche comprise entre 0,5 µm et 1,5 µm.

4. Procédé selon les revendications 1 à 3, caractérisé en ce qu'on transfère le dessin de la couche (5), par corrosion ionique réactive avec $CF_4$, dans la couche (4) de nitrure plasmatique et par corrosion ionique réactive avec l'oxygène, à une pression inférieure à 5 µbars, dans la couche de vernis photosensible (3).

5. Procédé selon la revendication 1, caractérisé en ce que, pour produire des structures polymères (3) à surfaces horizontales et sensiblement verticales à leurs bords, on applique un procédé d'inversion d'image modifié, dans lequel on applique une couche photosensible constituée par un vernis photosensible positif et renfermant de la 1-hydroxyéthyl-2-alcoyl-imidazoline, sur un substrat (1, 2), on l'expose selon l'image, on la durcit 10 à 20 minutes à 105°C, puis on l'expose sur toute sa surface et on la développe dans un révélateur alcalin, en obtenant une image de vernis photosensible négative par rapport au modèle à parois latérales sensiblement verticales.

6. Procédé selon la revendication 1, caractérisé en ce qu'on produit sur le substrat de silicium (1) comme première couche isolante (2), par oxydation thermique, une couche de silice ou, par dépôt à partir d'une atmosphère renfermant du silane, de l'ammoniac et de l'argon, on produit une couche de nitrure de silicium ou une couche double de silice et de nitrure de silicium.

7. Procédé selon les revendications 1 et 6, caractérisé en ce que, dans le cas où la silice constitue la première couche isolante, on applique sur les surfaces horizontales et sensiblement verticales de la structure polymère (3) et sur la surface horizontale de la première couche isolante (2), du nitrure de silicium plasmatique ou du polysilicium, comme seconde couche isolante (6) et, dans le cas où le nitrure de silicium constitue la première couche isolante, on applique de la silice plasmatique comme seconde couche isolante.

8. Procédé selon la revendication 1, caractérisé en ce qu'on applique du nitrure de silicium (6) sur les surfaces horizontales et sensiblement verticales de la structure de vernis photosensible (3) et la couche isolante (2) par dépôt plasmatique à partir d'une atmosphère renfermant du silane, de l'ammoniac et de l'argon, à une pression d'environ 1 millibar, une puissance de 100 watts (densité d'énergie de 0,05 watt/cm$^2$) et une température de 210°C.

9. Procédé selon les revendications 1 et 8, caractérisé en ce qu'on retire les zones horizontales de la couche de nitrure de silicium (6) par corrosion ionique réactive avec $CF_4$ et la structure de vernis photosensible (3) par corrosion ionique réactive avec de l'oxygène.

10. Procédé selon la revendication 1, caractérisé en ce que, dans le cas de la lithographie positive, la couche (2a; figure 14) de la matière de masque souhaitée est choisie dans le groupe de matières polymères comme un vernis photorésistant, un polyimide ou dans celui de matières inorganiques comme $SiO_2$, $Si_3N_4$, le polysilicium, un métal ou une combinaison de ces matières, et une couche diélectrique mince (2b) de nitrure plasmatique ou d'oxyde est placée sur la couche (2a).

11. Procédé selon les revendications 1 et 10, caractérisé en ce que l'on retire la couche diélectrique (2b) et la couche (2a) dans les régions non couvertes par le masque de parois latérales (6) par corrosion ionique réactive, puis l'on élimine par corrosion le masque de paroi latérale et les résidus sous-jacents de la couche diélectrique (2b) en obtenant un masque ayant les dimensions du modèle, mais constitué par la matière de la couche (2b; figure 15).

12. Procédé selon la revendication 1, caractérisé en ce que, dans le cas de la lithographie négative, on applique par filage sur le substrat (1, 2) avec les parois latérales (6) des matières de masque (7) choisies dans le groupe des matières polymères telles qu'un vernis photosensible ou un polyimide ou le verre, ou bien l'on applique par pulvérisation des matières comme $SiO_2$, $Si_3N_4$, MgO, le polysilicium ou $Al_2O_3$, ou des métaux, ou bien on les applique par dépôt chimique à partir de la phase gazeuse.

13. Procédé selon les revendications 1 et 12, caractérisé en ce qu'on applique sur le substrat (1, 2) avec des parois latérales (6) de nitrure de silicium, comme matière de masque (7), de la silice par pulvérisation cathodique, en appliquant une première couche d'environ 1,3 μm d'épaisseur dans des conditions usuelles, et une seconde couche de silice d'environ 0,5 μm d'épaisseur avec une puissance anodique accrue pour obtenir un meilleur caractère planaire de la surface.

14. Procédé selon les revendications 1 et 12, caractérisé en ce qu'on fait croître une couche de silice (7a) d'environ 0,5 μm d'épaisseur, par dépôt chimique à partir de la phase gazeuse, uniformément sur toute la périphérie des parois de nitrure de silicium (6), et l'on applique ensuite par pulvérisation cathodique une couche de silice (7b) d'environ 1 μm d'épaisseur, à une puissance anodique accrue, pour augmenter l'épaisseur de la couche de silice et pour obtenir un meilleur caractère planaire de la surface.

15. Procédé selon la revendication 14, caractérisé en ce qu'on applique par filage une couche de vernis photosensible, au lieu de la couche de silice (7b) ou des couches de silice (7a et 7b), et on les corrode de nouveau, pour améliorer le caractère planaire de la surface.

16. Procédé selon la revendication 1, caractérisé en ce que, pour retirer les parois latérales (6), on retire la couche de silice (7) ou la couche de vernis photosensible sur toute la surface par corrosion ionique réactive, jusqu'à ce que les sommets des parois latérales (6) soient dégagées, et ensuite on retire le nitrure de silicium ou l'oxyde par corrosion plasmatique ou par corrosion par voie humide, et en ce qu'on approfondit les ouvertures (8) jusqu'à la surface du substrat de silicium (1) par corrosion ionique réactive sur toute la surface.

17. Procédé selon la revendication 16, caractérisé en ce qu'après le retrait de la couche de silice (7), on retire les parois de nitrure de silicium par corrosion plasmatique avec $CF_4$, et l'on approfondit les ouvertures (8) jusqu'à la surface du substrat de silicium (1) par corrosion ionique réactive sur toute la surface avec $CF_4$.

18. Procédé selon une ou plusieurs des revendications 1 à 17, dans son application à la production d'une région d'isolation diélectrique profonde de largeur (9) sub-micrométrique dans un corps de silicium (1) caractérisé en ce que,

à travers le masque (7) achevé, on forme par corrosion des creux ou tranchées (9) dans le substrat de silicium (1) par corrosion ionique réactive avec du chlore et/ou des gaz oxygénés (figure (10);

on remplit les tranchées (9), uniquement par oxydation thermique (figure 11), ou avec un oxyde thermique (11), un nitrure (12) et une matière plastique (13, figure 13);

et, dans le cas du remplissage uniquement par oxydation thermique, après le retrait par corrosion sur toute la surface de l'oxyde de la surface du corps de silicium (1), on effectue une réoxydation, en obtenant une couche de silice (10) (figure 12).

19. Procédé selon la revendication 18, caractérisé en ce qu'on produit les tranchées (9) dans le substrat de silicium (1) par corrosion ionique réactive avec une combinaison chlore/argon, $SF_6$/chlore/hélium, $CCl_2F_2$/oxygène ou $SiF_4$/chlore/hélium, ou des mélanges gazeux renfermant de l'argon, à travers le masque de silice (7).

20. Procédé selon les revendications 18 et 19, caractérisé en ce que, dans le cas où l'on produit en même temps des tranchées profondes et peu profondes, on masque les tranchées peu profondes pendant la poursuite de la formation par corrosion des tranchées profondes.

21. Procédé selon les revendications 18 à 20, caractérisé en ce qu'on remplit les tranchées par oxydation thermique avec de la silice (figure 11), ou bien l'on effectue une oxydation thermique pour produire environ 25 nm de silice (11), un dépôt d'environ 50 nm de nitrure de silicium (12) à partir de la phase gazeuse, et l'on remplit alors les tranchées complètement de polyimide (13) (figure 13).

22. Procédé selon les revendications 18 et 21, caractérisé en ce que, dans le cas où l'on remplit les tranchées par oxydation thermique, on retire l'oxyde sur la surface (1) du substrat de silicium par corrosion ionique réactive sur toute la surface avec $CHF_3$, puis l'on réoxyde le substrat de silicium (1) pour obtenir une épaisseur de couche d'oxyde (10) nécessaire pour les opérations subséquentes.

FIG.1A

POLYMERMATERIAL

PLASMA-SiN (SiO2)

SiO2 (Si3N4)

SUBSTRAT.

FIG.1B

SiN (SiO2)

SiO2 (Si3N4)

SUBSTRAT

FIG.1C

MASKEN-MATERIAL

SiO2 (Si3N4)

SUBSTRAT

1

MASKE

SUBSTRAT

**FIG.1D**

GRABEN

SUBSTRAT

**FIG.1E**

SiO₂ ODER
POLYIMID

**FIG.1F**

POLYMERMATERIAL

PLASMA-Si N(SiO₂)

SiO₂ (Si₃N₄)

MASKENMATERIAL

SUBSTRAT

FIG. 2 A

MASKENBREITE

MASKEN-
MATERIAL

SUBSTRAT

FIG. 2B

MASKENMATERIAL

SUBSTRAT

FIG. 2C

FIG. 3

FIG. 4

6

3

2

1

400 nm

FIG.5

250 nm

CF₄  RIE

6

O₂ RIE

CF₄ RIE

2

1

CF₄ RIE

FIG.6

FIG. 7 A

FIG. 8

FIG. 7B

FIG. 7C

$0.2 - 0.3 \, \mu m$

8

7

1

CF₄ RIE

## FIG. 9

$0.5 \, \mu m$

7

9

1

Cl₂/Ar
RIE

## FIG. 10

|← 1 μm →|

10

9

1

**FIG. 11**

CHF₃ RIE

10

9

1

≈ 5 μm

**FIG. 12**

EP 0 111 086 B1

FIG.13

FIG.14

FIG.15

| 1 μm |

SEM 1    (ENTSPRICHT FIG. 4)
LACK MIT VERTIKALEN SEITENWÄNDEN GEÄTZT
BEI TIEFEM SAUERSTOFFDRUCK MIT REAKTIVEM
IONEN ÄTZEN

SEM 2    (ENTSPRICHT FIG. 5)
NITRID BEDECKT LACK MIT VERTIKALEN WÄNDEN

EP 0 111 086 B1

SEM 3    (ENTSPRICHT FIG. 6)
         VERTIKALE WÄNDE AUS NITRID CA 0,3 μm BREIT

SEM 4    (ENTSPRICHT FIG. 7A)
         NITRIDWÄNDE EINGEBETTET IN AUFGEPUTTERTES
         QUARZ (1,3 μm STANDARD $SiO_2$ ; 0,5 μm PLANAR $SiO_2$ )

SEM 5     (ENTSPRICHT FIG. 9)
Si O$_2$ MASKE GEÖFFNET BIS ZUM Si - SUBSTRAT

SEM 6     (ENTSPRICHT FIG. 10)
GRABEN IN Si GEÄTZT, Si O$_2$ - MASKE GESTRIPPT

25

SEM 7 (ENTSPRICHT FIG. 12)
Si GRÄBEN AUFGEFÜLLT DURCH THERMISCHE OXIDATION